(19) Europäisches Patentamt
European Patent Office
Office européen des brevets

(11) **EP 4 517 351 A1**

(12) **EUROPEAN PATENT APPLICATION**

(43) Date of publication:
**05.03.2025  Bulletin 2025/10**

(21) Application number: **24196702.5**

(22) Date of filing: **27.08.2024**

(51) International Patent Classification (IPC):
**G01R 31/367** (2019.01)    **G01R 31/392** (2019.01)

(52) Cooperative Patent Classification (CPC):
**G01R 31/367; G01R 31/392**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **31.08.2023  KR 20230115852**

(71) Applicant: **LG Energy Solution, Ltd.**
**Seoul 07335 (KR)**

(72) Inventors:
• **KIM, Ji-Yeon**
**34122 Daejeon (KR)**
• **KIM, Young-Deok**
**34122 Daejeon (KR)**
• **PARK, Jun-Cheol**
**34122 Daejeon (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **APPARATUS AND METHOD FOR ESTIMATING SOH**

(57)    An apparatus for estimating a SOH according to one aspect of the present disclosure may include a profile obtaining unit configured to obtain an OCV profile for a plurality of OCVs of a battery measured at different time points; a profile correcting unit configured to generate an adjusted positive electrode profile and an adjusted negative electrode profile by adjusting a preset reference positive electrode profile and a preset reference negative electrode profile to correspond to the OCV profile; and a control unit configured to extract a diagnosis factor for the battery from at least one of the adjusted positive electrode profile and the adjusted negative electrode profile, and estimate a SOH of the battery based on the extracted diagnosis factor.

FIG. 1

**Description**

TECHNICAL FIELD

The present disclosure relates to a battery diagnosis apparatus and battery diagnosis method, as well as an apparatus and method for estimating a SOH (State Of Health).

BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

A lot of research is being conducted on these batteries in terms of high-capacity and high-density, but the aspect of improving lifespan and safety is also important. In order to improve the safety of the battery, technology to accurately diagnose the current state of the battery is required.

Conventionally, the state of the battery is diagnosed by analyzing the battery profile, which represents the correspondence relationship between capacity and voltage of the battery. For example, during the battery charging process, capacity and voltage are measured, and the battery state is diagnosed through analysis of the battery profile, which represents the correspondence relationship between the measured capacity and voltage. As another example, the state of the battery may be diagnosed based on the capacity and voltage measured during the battery discharge process.

Here, in order to more accurately diagnose the current state of the battery, a battery profile that accurately reflects the current state of the battery is required. However, in order to obtain this battery profile, there is a problem that low rate charging and discharging such as 0.05 C (C-rate) is required. That is, in the past, low-rate charging and discharging is required to diagnose the state of the battery, so there are limitations in diagnosing the state of the battery. For example, since it takes about 20 hours to fully charge the battery at 0.05 C, there is a problem that a considerable amount of time is required to diagnose the condition of the battery according to the conventional low-rate charging and discharging.

DISCLOSURE

Technical Problem

The present disclosure is designed to solve the problems of the related art. One aspect of the present disclosure is to provide a battery diagnosis apparatus and battery diagnosis method. In another aspect, the present disclosure provides an apparatus and method for estimating a SOH. According to some embodiments of theses aspects, the diagnosis of the battery or the SOH of a battery may be based on an OCV (Open Circuit Voltage) of the battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

Technical Solution

An apparatus for estimating a SOH according to one aspect of the present disclosure may comprise a profile obtaining unit configured to obtain an OCV profile for a plurality of OCVs of a battery measured at different time points; a profile correcting unit configured to generate an adjusted positive electrode profile and an adjusted negative electrode profile by adjusting a preset reference positive electrode profile and a preset reference negative electrode profile to correspond to the OCV profile; and a control unit configured to extract a diagnosis factor for the battery from at least one of the adjusted positive electrode profile and the adjusted negative electrode profile, and estimate a SOH of the battery based on the extracted diagnosis factor.

The plurality of OCVs may be configured to include an OCV measured at a time point when the battery transitions from an idle state to a discharge state and an OCV measured while a condition that a discharge current of the battery is equal to or less than a preset threshold current is maintained during a preset reference time or more.

The plurality of OCVs may be configured to include a plurality of OCVs measured within a preset reference period.

The reference period may be set based on a preset target period, a period required to measure a preset number of OCVs, a period required for the SOH of the battery to be reduced to a preset reference SOH, or a combination thereof.

The profile correcting unit may be configured to generate a comparison full-cell profile based on the reference positive electrode profile and the reference negative electrode profile, and generate the adjusted positive electrode profile and the adjusted negative electrode profile by adjusting the reference positive electrode profile and the reference negative electrode profile until the generated comparison full-cell profile corresponds to the OCV profile.

The profile correcting unit may be configured to determine a target capacity range corresponding to the OCV profile and compare the comparison full-cell profile and the OCV profile in the target capacity range.

The control unit may be configured to estimate a SOH of the battery by comparing the value of the diagnosis factor with a reference value preset for the diagnosis factor.

The control unit may be configured to estimate at least one of a positive electrode SOH, a negative electrode SOH, an available lithium SOH, and a capacity SOH for the battery depending on the type of the diagnosis factor.

The control unit may be configured to extract at least one of a positive electrode factor based on the adjusted positive electrode profile and a negative electrode factor based on the adjusted negative electrode profile as the diagnosis factor.

The positive electrode factor may include, may be based on or may be a function of at least one of a positive electrode participation initiating point, a positive electrode participation finalizing point and a positive electrode change rate of the adjusted positive electrode profile of the battery. The change rate may for example be the slope of the adjusted positive electrode profile.

The negative electrode factor may include, may be based on or may be a function of at least one of a negative electrode participation initiating point, a negative electrode participation finalizing point, and a negative electrode change rate of the adjusted negative electrode profile of the battery.

The control unit may be configured to adjust a usage condition for the battery based on the estimated SOH.

A battery pack according to another aspect of the present disclosure may comprise the apparatus for estimating a SOH according to the present disclosure.

A vehicle according to still another aspect of the present disclosure may comprise the apparatus for estimating a SOH according to the present disclosure.

A server according to still another aspect of the present disclosure may comprise the apparatus for estimating a SOH according to the present disclosure.

A method for estimating a SOH according to still another aspect of the present disclosure may comprise a profile obtaining step of obtaining an OCV profile for a plurality of OCVs of a battery measured at different time points; a profile adjusting step of generating an adjusted positive electrode profile and an adjusted negative electrode profile by adjusting a preset reference positive electrode profile and a preset reference negative electrode profile to correspond to the OCV profile; a diagnosis factor extracting step of extracting a diagnosis factor for the battery from at least one of the adjusted positive electrode profile and the adjusted negative electrode profile; and a SOH estimating step of estimating a SOH of the battery based on the extracted diagnosis factor.

A further aspect of the present disclosure provides a battery diagnosis apparatus , comprises: a profile obtaining unit configured to obtain an OCV profile of a battery, the OCV profile being indicative of OCV as a function of a capacity; a profile correcting unit configured to generate a first profile by adjusting a first reference profile indicative of OCV as a function of a capacity, to correspond to the OCV profile; and a control unit configured to determine a state of the battery using the first profile.

In a further example, the profile correcting unit of the the battery diagnosis apparatus is configured to generate a second profile by adjusting a second reference profile to correspond to the OCV profile. Further, the first reference profile may be a reference positive electrode profile, and the second reference profile may be a reference negative electrode profile.

In a further example, the control unit of the battery diagnosis apparatus may be further configured to determine a diagnosis factor of the battery using the first profile and/or the second profile, and to determine the state of the battery as a function of the diagnosis factor.

In another example, the OCV profile referred to above may be obtained from one or more of the following:

- an OCV measured when the battery is an idle state; and/or

- an OCV measured when the battery transitions from the idle state to a discharge state; and/or

- an OCV measured while a discharge current of the battery is equal to or less than a preset threshold current; and/or

- an OCV measured after or while the discharge current of the battery is maintained or has been maintained equal to or less than the preset threshold current for a predetermined duration.

The OCV profile may be obtained from a plurality of OCV measurements of the battery that are measured within a reference period. In accordance with embodiments of this disclosure, the reference period may be either one of the following:

- a predetermined or preconfigured time period; or

- a period of time

  ∘ in which a SOC of the battery progressively decreases by at least a threshold amount, e.g. 30%, at least 40%, at least 50% or more;

  ∘ required to perform a predetermined or preconfigured number of consecutive and/or periodic OCV measurements;

  ∘ in which a SOC of the battery decreases a lower threshold SOC, e.g. below 50%, below 40% or below 30%;

  ∘ in which OCVs obtained in a predetermined or preconfigured number of consecutive OCV measurements monotonously or strictly monotonously decrease over time; and/or

  ∘ between two charging cycles of the battery.

In further examples, the profile correcting unit may be configured to generate a comparison profile that is indicative of the OCV as a function of the capacity, from the first reference profile and the second reference profile, and to adjust the first reference profile and the second reference profile so that the comparison profile corresponds to the OCV profile.

In another example, the profile correcting unit may obtain a target capacity range corresponding to the OCV profile and to compare the comparison profile and the OCV profile in the target capacity range.

In a further example the state of the battery that is determined by the control unit comprises any, some or all of the following: a positive electrode state, a negative electrode state, an available lithium state, and a capacity state of the battery. The state may be for example a State of Health (SOH).

In a further embodiment, the diagnosis factor may be or may include a positive electrode factor that is obtained from the first profile and/or a negative electrode factor that is obtained from the second profile. For example, the positive electrode factor may include, may be based on or may be a function of at least one of a positive electrode participation initiating point, a positive electrode participation finalizing point, and a positive electrode change rate of the battery obtained from the first profile. The negative electrode factor may include, may be based on or may be a function of at least one of a negative electrode participation initiating point, a negative electrode participation finalizing point, and a negative electrode change rate of the battery obtained from the second profile.

In another example, the control unit may be configured to automatically adjust a usage condition for the battery as a function of the state of the battery.

A further aspect of the present disclosure provides a battery pack, comprising the battery diagnosis apparatus according to any one of the examples thereof discussed herein above or in the following.

A further aspect of the present disclosure provides a vehicle, comprising the battery diagnosis apparatus according to any one of the examples thereof discussed herein above or in the following.

A further aspect of the present disclosure provides a server, comprising the battery diagnosis apparatus according to any one of the examples thereof discussed herein above or in the following.

A further aspect of the present disclosure provides a battery diagnosis method, comprising the steps: obtaining an OCV profile of a battery, the OCV profile being indicative of OCV as a function of a capacity; generating a first profile by adjusting a first reference profile indicative of OCV as a function of a capacity, to correspond to the OCV profile; and determining a state of the battery using the first profile.

Advantageous Effects

According to one aspect of the present disclosure, since the battery diagnosis apparatus estimates the SOH of the battery using the OCV profile, it has an advantage of not forcing charging and discharging of the battery to obtain the battery profile. In other words, according to the present disclosure, charging and discharging of the battery is not required in the process of estimating the SOH of the battery. Therefore, compared to the conventional method that requires obtaining a battery profile during the charging and discharging process to estimate the SOH of the battery, the present disclosure has an advantage of quickly estimating the SOH of the battery based on the OCV profile.

In addition, according to one aspect of the present disclosure, the apparatus for estimating a SOH has an advantage of diagnosing the state of the battery from various perspectives, based on the type of diagnosis factor that can be extracted.

The effects of the present disclosure are not limited to the effects mentioned above, and other effects not mentioned will be clearly understood by those skilled in the art from the description of the claims.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a diagram schematically showing an apparatus for estimating a SOH according to an embodiment of the present disclosure.

FIG. 2 is a diagram schematically showing an OCV profile according to an embodiment of the present disclosure.

FIG. 3 is a diagram showing a measured OCV of the battery according to an embodiment of the present disclosure.

FIG. 4 is a diagram schematically showing a reference positive electrode profile and a reference negative electrode profile according to an embodiment of the present disclosure.

FIG. 5 is a diagram schematically showing a comparison full-cell profile according to an embodiment of the present disclosure.

FIG. 6 is a diagram schematically showing a comparison full-cell profile and an OCV profile according to an embodiment of the present disclosure.

FIGS. 7 to 14 are diagrams for explaining the process of adjusting a reference positive electrode profile and a reference negative electrode profile according to an embodiment of the present disclosure.

FIG. 15 is a diagram schematically showing an exemplary configuration of a battery pack according to another embodiment of the present disclosure.

FIG. 16 is a diagram schematically showing an exemplary configuration of a vehicle according to still another embodiment of the present disclosure.

FIG. 17 is a diagram schematically showing a method for estimating a SOH according to still another embodiment of the present disclosure.

DETAILED DESCRIPTION

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

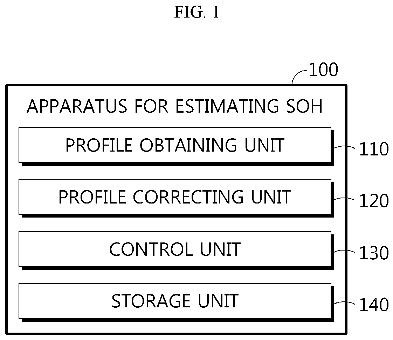

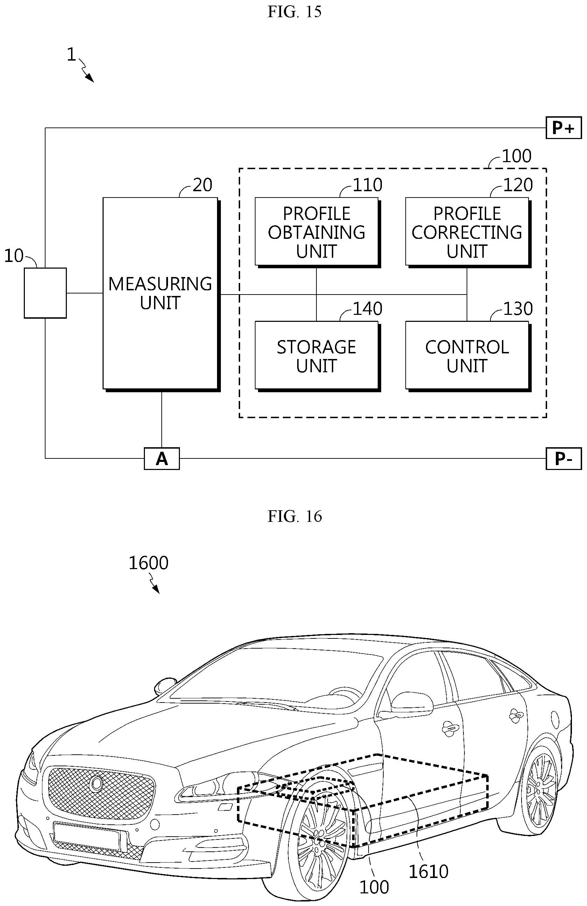

FIG. 1 is a diagram schematically showing an apparatus 100 according to an embodiment of the present disclosure. The apparatus 100 may be, for example, a battery diagnosis apparatus. The apparatus 100 may be configured for estimating a SOH (State Of Health) of a battery, such as battery 10 (see FIG. 15).

Referring to FIG. 1, the apparatus 100 may include a profile obtaining unit 110, a profile correcting unit 120, and a control unit 130.

The profile obtaining unit 110 may be configured to obtain an OCV profile Rocv for a plurality of OCVs of a battery measured at different time points.

As an example, the battery may be a lithium-ion battery or a lithium polymer battery. Additionally, the type of battery may be a cylindrical type, a prismatic type, or a pouch type. The battery may refer to an independent cell that has a negative terminal and a positive terminal. Alternatively, the battery may refer to a battery bank, a battery module or a battery pack in which a plurality of cells are connected in series and/or parallel. Below, for convenience of explanation, the battery may be considered one independent cell in the following description.

Here, the OCV profile Rocv is a profile that represents the correspondence relationship between the OCV and a capacity of the battery. Specifically, the OCV of a battery can be measured at a time point that satisfies a predetermined condition. More specifically, the plurality of OCVs may be configured to include OCV measured at the time point when the battery transitions from the idle state to the discharge state and OCV measured while the condition that the discharge current of the battery is equal to or less than a preset threshold current is maintained for a preset reference time or more.

Here, an OCV may be measured across the negative terminal and the positive terminal of an individual cell of the battery, or an OCV may be measured across a negative terminal and a positive terminal of the battery including a plurality of battery cells connected in series and/or parallel.

For example, the OCV of the battery can be measured at the time point when the battery is in an idle state or when the battery transitions from the idle state to the discharge state. Here, the idle state refers to a stabilized state in which the battery is maintained in an unloaded state for a certain period of time or more. For example, when a battery is included in a vehicle, the OCV of the battery can be measured at the key-on time point when the engine of the vehicle that has been parked for a certain period of time is turned on. Also, the capacity of the battery can be determined according to the capacity at the key-off time point when the engine of the vehicle is turned off.

In another example, the OCV of the battery can be measured while a condition is met. For example, the OCV of the battery can be measured while the discharge current of the battery is equal to or less than a preset threshold current. In another example, the OCV of the battery can be measured while the condition that the discharge current of the battery is equal to or less than a preset threshold current is maintained for the preset reference time or more. Here, the state in which the discharge current of the battery is equal to or less than the threshold current means a state in which the discharge amount of the battery can be ignored. In other words, when the battery is being discharged but the amount of discharge is minimal, the measured voltage of the battery can be estimated as OCV. This is because, if the discharge amount of the battery is negligible, the battery can be considered to be in a stable state even if the battery is being discharged beyond the reference time. For example, when a battery is included in a vehicle and the vehicle is stopped for a reference time or more, the battery may be continuously discharged to supply power to electrical components. However, the discharge amount of the battery to supply power to electronic components is very small based on the capacity of the battery. Therefore, although the battery is actually in a discharged state, the voltage of the battery can be estimated as OCV.

In another example, the OCV of the battery can be measured the discharge current of the battery is maintained or has been maintained equal to or less than the preset threshold current for a predetermined duration.

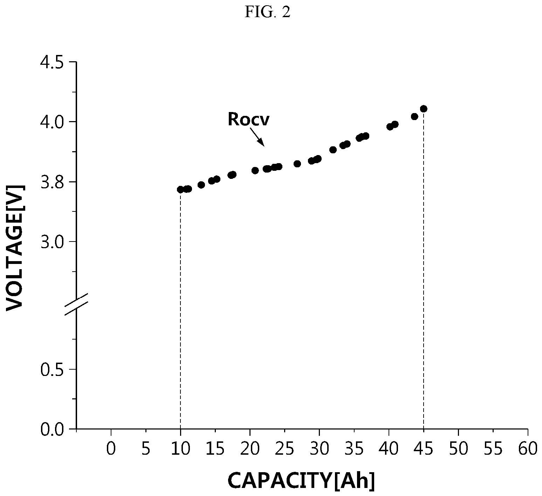

FIG. 2 is a diagram schematically showing an OCV profile Rocv according to an embodiment of the present disclosure. Referring to FIG. 2, the OCV profile Rocv represents the correspondence relationship between the OCV and capacity of the battery in a capacity range of 10 (Ah) to 45 (Ah). As explained previously, the conditions under which OCV can be measured are limited, so the plurality of OCVs included in the OCV profile Rocv may be discontinuous.

For example, the profile obtaining unit 110 may directly receive the OCV profile Rocv from the outside. That is, the profile obtaining unit 110 can obtain the OCV profile Rocv by receiving the OCV profile Rocv by being connected to the outside wired and/or wirelessly.

As another example, the profile obtaining unit 110 may receive battery information about the OCV (V) and capacity (Q) of the battery. Additionally, the profile obtaining unit 110 may generate an OCV profile Rocv based on the received battery information. That is, the profile obtaining unit 110 can obtain the OCV profile Rocv by directly generating the OCV profile Rocv based on battery information.

The profile obtaining unit 110 may be connected to enable communication with the profile correcting unit 120. For example, the profile obtaining unit 110 may be connected to the profile correcting unit 120 wired and/or wirelessly. The profile obtaining unit can transmit the obtained OCV profile Rocv to the profile correcting unit 120.

The profile correcting unit 120 may be configured to generate an adjusted positive electrode profile and an adjusted negative electrode profile by adjusting a preset reference positive electrode profile Rp and a preset reference negative electrode profile Rn to correspond to the OCV profile Rocv.

The reference positive electrode profile Rp may be a profile representing a correspondence relationship between the capacity and OCV of a reference positive electrode cell preset to correspond to the positive electrode of the battery. For example, the reference positive electrode cell may be a positive electrode coin half-cell or a positive electrode of a three-electrode cell. Additionally, the reference negative electrode profile Rn may be a profile representing a correspondence relationship between the capacity and OCV of a reference negative electrode cell preset to correspond to the negative electrode of the battery. For example, the reference negative electrode cell may be a negative electrode coin half-cell or a negative electrode of a three-electrode cell.

Specifically, the profile correcting unit 120 may adjust the reference positive electrode profile Rp and the reference negative electrode profile Rn to correspond to the OCV profile Rocv. More specifically, the profile correcting unit 120 may adjust the reference positive electrode profile Rp and the reference negative electrode profile Rn to generate an adjusted positive electrode profile and an adjusted negative electrode profile. Additionally, the profile correcting unit 120 may generate a comparison full-cell profile S from the adjusted positive electrode profile and the adjusted negative electrode profile. The profile correcting unit 120 may adjust the reference positive electrode profile Rp and the reference negative electrode profile Rn until the comparison full-cell profile S corresponds to the OCV profile Rocv. Here, the target capacity range T of the OCV profile Rocv may be different from the capacity range of the comparison full-cell profile S. Therefore, the reference positive electrode profile Rp and the reference negative electrode profile Rn can be adjusted depending on the correspondence between the comparison full-cell profile S and the OCV profile Rocv in the target capacity range T.

For example, the profile correcting unit 120 may generate a plurality of comparison full-cell profiles S by shifting the reference positive electrode profile Rp and the reference negative electrode profile Rn or scaling the capacities thereof, and specify a comparison full-cell profile S with the minimum error with the OCV profile Rocv among the plurality of comparison full-cell profiles S. Also, an adjusted positive electrode profile and an adjusted negative electrode profile corresponding to the specified comparison full-cell profile S can be determined.

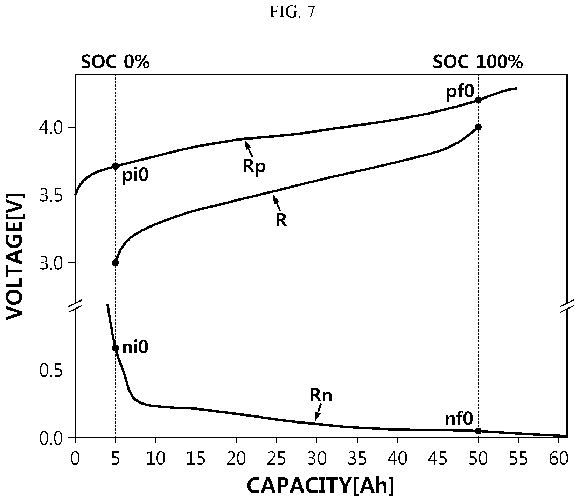

In relation to this, a more specific embodiment in which the profile correcting unit 120 determines the positive electrode profile of the battery by adjusting the reference positive electrode profile Rp and the reference negative electrode profile Rn to correspond to the OCV profile Rocv will be described later with reference to FIGS. 7 to 14.

The control unit 130 may be configured to extract a diagnosis factor for the battery from at least one of the adjusted positive electrode profile and the adjusted negative electrode profile.

Specifically, the control unit 130 can extract a diagnosis factor related to the positive electrode from the adjusted positive electrode profile. Additionally, the control unit 130 can extract a diagnosis factor related to the negative electrode from the adjusted negative electrode profile. For convenience of explanation, specific examples regarding the diagnosis factor will be described later.

The control unit 130 may be configured to diagnose the SOH of the battery based on the extracted diagnosis factor.

Specifically, the control unit 130 may be configured to estimate the SOH of the battery by comparing the value of the diagnosis factor with a reference value preset for the diagnosis factor.

Here, the preset reference value may be a value obtained in advance for a battery in a BOL (Beginning of Life) state. Preferably, the OCV profile Rocv for the battery in the BOL state can represent the correspondence relationship between OCV and capacity for the entire capacity range. The control unit 130 can determine the reference value corresponding to the extracted diagnosis factor from the OCV profile Rocv for the battery in the BOL state. In other words, the reference value is a state value of the battery in the BOL state, and the diagnosis factor is a state value of the battery in the current state. Accordingly, the control unit 130 can estimate the SOH of the battery based on the diagnosis factor indicating the current state of the battery and the reference value indicating the BOL state of the battery.

The apparatus 100 according to an embodiment of the present disclosure can estimate the SOH of a battery based on the OCV of the battery measured under predetermined conditions. In other words, according to the present disclosure, there is an advantage that low-rate charging and discharging for SOH estimation is not mandatory.

For example, if low-rate charging and discharging at 0.05 C is required to estimate SOH, use of the battery may be limited for about 20 hours. In contrast, the apparatus 100 can estimate the SOH of a battery by only obtaining the OCV profile Rocv that includes a plurality of OCVs. Also, the conditions under which OCV is measured are conditions in which the use of the battery is not forcibly restricted. Therefore, since the apparatus 100 can quickly estimate the SOH of the battery based on the OCV profile Rocv without restricting the use of the battery, there is an advantage that the conventional problem in which the use of the battery must be excessively limited to estimate SOH can be solved.

Meanwhile, the control unit 130 included in the apparatus 100 optionally include a processor, an application-specific integrated circuit (ASIC), other chipset, a logic circuit, a register, a communication modem, a data processing device, etc. known in the art to execute various control logics performed in the present disclosure. Also, when the control logic is implemented as software, the control unit 130 may be implemented as a set of program modules. At this time, the program module may be stored in the memory and executed by the control unit 130. The memory may be inside or outside the control unit 130 and may be connected to the control unit 130 by various well-known means.

In addition, the apparatus 100 may further include a storage unit 140. The storage unit 140 may store data necessary for operation and function of each component of the apparatus 100 for estimating a SOH, data generated in the process of performing the operation or function, or the like. The storage unit 140 is not particularly limited in its kind as long as it is a known information storage means that can record, erase, update and read data. As an example, the information storage means may include RAM, flash memory, ROM, EEPROM, registers, and the like. In addition, the storage unit 140 may store program codes in which processes executable by the control unit 130 are defined.

For example, the storage unit 140 can store the OCV profile Rocv, the reference positive electrode profile Rp, the reference negative electrode profile Rn, the adjusted positive electrode profile, the adjusted negative electrode profile, and the diagnosis factor.

The plurality of OCVs can be configured to include a plurality of OCVs measured within a preset reference period.

Specifically, the OCV may have limited measurement conditions. In other words, the time at which the plurality of OCVs are measured may be aperiodic. For example, it is assumed that the vehicle is started only once a day and that the stopping time of the vehicle is less than a reference time. In this case, because OCV is measured only at the time point when the vehicle engine is turned on, one OCV can be measured per day. Therefore, the plurality of OCVs included in the OCV profile Rocv may be values measured with a time interval of one day or more.

Considering the OCV measurement conditions, a grouping condition for the plurality of OCVs used to estimate the SOH of the battery is needed. In other words, if the SOH of the battery is estimated using the plurality of OCVs obtained over an excessively long period of time, the battery may deteriorate further during that period, so the estimated SOH of the battery may not be accurate. Therefore, the OCV profile Rocv can only include a plurality of OCVs measured within the preset or configurable reference period. The reference period may be preset or configured based on one or more of the following conditions and considerations.

For example, the OCV profile Rocv may include a plurality of OCVs measured within the last two weeks, within the last 7 days, etc. Therefore, the SOH may be estimated based on the OCV profile Rocv, which includes only a plurality of OCVs measured within the reference period, can well reflect the current state of the battery.

For example, the reference period may be set experimentally or theoretically, or may be set in consideration of the operation pattern (e.g., driving pattern or charge/discharge pattern) for the corresponding battery.

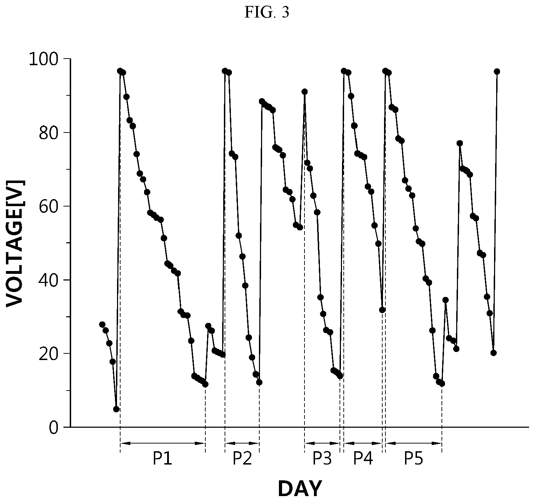

FIG. 3 is a diagram showing a measured OCV of the battery according to an embodiment of the present disclosure.

For example, in the embodiment of FIG. 3, the first to fifth periods P1, P2, P3, P4, P5 may be shorter than the preset reference period. Therefore, the apparatus 100 can continuously diagnose the state of the battery by estimating the SOH of the battery based on the OCV profile Rocv for each of the first to fifth periods P1, P2, P3, P4, P5.

In another example, the reference period may be set to or based on a period required to measure a preset or configurable number of OCVs. For example, the number of OCV measurements may be proportional to the level of detail or accuracy of the OCV profile Rocv. In other words, the larger the number of measured OCVs, the higher the level of detail of the OCV profile Rocv becomes, so the results of adjusting the reference positive electrode profile Rp and the reference negative electrode profile Rn may better reflect the current state of the battery. Therefore, the period until non-overlapping OCVs are measured as many as a preset number (e.g., 5, 10, 20, 30, ...) may be preset or configured as the reference period.

In FIG. 2, the a plurality of OCV values is measured for capacity in a target capacity range T between 45 Ah and 10Ah and provide an accurate OCV profile Rocv. The range of capacity of the battery covered by the OCV measurements may also effect the level of detail or accuracy of the OCV profile Rocv. Therefore, in another example, the reference period may be preset or configured based on a (minimum) range of capacity values for which OCV measurements are performed. This range may also be denoted a target capacity range. For example, the reference period may be selected so that a capacity or a SOC of the battery progressively decreases by at least a threshold amount, e.g. 30%, at least 40%, at least 50% or more. The decrease by the given amount may be relative to the capacity or SOC that defines the staring condition of the reference period. For example, the starting condition may be a starting capacity or starting SOC that marks the start of the reference period. This starting condition may be, for example, the capacity or SOC reached by the battery at the end of a charging cycle or an upper threshold capacity (e.g. 50 %, 60%, 70%, 80%, 85%, etc.) or upper threshold SOC of the battery (e.g. 60%, 70%, 80%, 90%, 100%). In another example, or in addition, the reference period may be selected so that the capacity or SOC of the battery decreases below a lower threshold reference, e.g. a lower threshold capacity or lower threshold SOC (e.g. 50%, 40%, 30%, etc.), within the reference period. Optionally further, the starting condition for the reference period, e.g. the starting capacity or starting SOC for the reference period, may be an upper threshold capacity (e.g. 50 %, 60%, 70%, 80%, 85%, etc.) or upper threshold SOC of the battery (e.g. 60%, 70%, 80%, 90%, 100%), which should be higher than the lower threshold capacity or lower threshold SOC by an amount that ensures that the reference period includes a progressive decrease of the capacity or SOC of the battery by at least the threshold amount.

In yet another example, the reference period may also be preset or configured so that the reference period contains OCVs of a predetermined or preconfigured number of consecutive OCV measurements that monotonously or strictly monotonously decrease over time. For example, the end of the reference period may thus be defined by reaching the predetermined or preconfigured number of consecutive OCV measurements. Also this example may be combined with the previous examples of selecting the reference period. For example, the maximum duration of a reference period may be set to two weeks relative to a starting condition of the reference period, but the reference period may end earlier, e.g. when reaching the predetermined or preconfigured number of consecutive OCV measurements providing OCVs that monotonously or strictly monotonously decrease over time. In addition, it can also be ensured that the reference period covers a sufficiently large range of capacity values or SOC values of the battery obtained by the OCV measurements.

In another example, the reference period may also be defined relative to the charging cycles of the battery. For example, a reference period may start at the end of a charging cycle of the battery and may end with the beginning of the next charging cycle of the battery. For example, a reference period may be started only when the charging cycle is reaching the upper threshold capacity or SOC, and/or when the lower threshold capacity or SOC has been reached when starting the next charging cycle. Also in this example, additional conditions for defining the reference period may be considered, e.g. the maximum duration of the reference period relative to its start may be limited to a maximum duration of time (e.g. preset or configurable maximum time period (e.g. 2 weeks), or a preset time period corresponding to decrease of the SOH of the battery by a preset reference (e.g., 0.1%)).

In still another example, the reference period may be set to or based on a period required for the SOH of the battery to decrease by or to a preset reference SOH. For example, when the frequency of OCV measurement is low, the plurality of OCVs included in the OCV profile Rocv may be measured at different SOHs. In this case, a problem arises in that the results of adjusting the reference positive electrode profile Rp and the reference negative electrode profile Rn based on the OCV profile Rocv reflect even the past state of the battery. Accordingly, the period until the SOH of the battery decreases to a preset reference SOH (e.g., 0.1%) may be determined the reference period. For example, the reference period should be configured or preset to be equal or smaller than, i.e. not to exceed, the period until the SOH of the battery decreases to a preset reference SOH.

In still another embodiment, the reference period may be set to a shortest period among the preset target period, the period required to measure OCVs of a preset number, and the period required to reduce the SOH of the battery to the preset reference SOH.

Although a limited embodiment of the reference period has been described above, it should be noted that the reference period for generating an appropriate OCV profile Rocv used to diagnose the current state of the battery may be set by considering various aspects.

The apparatus 100 according to the present disclosure has an advantage of more accurately estimating the SOH of the battery by limiting the measurement time points of the plurality of OCVs used to estimate SOH.

Below, an embodiment in which the profile correcting unit 120 adjusts the reference positive electrode profile Rp and the reference negative electrode profile Rn will be described in detail.

The profile correcting unit 120 may be configured to generate a comparison full-cell profile S based on the reference positive electrode profile Rp and the reference negative electrode profile Rn.

Specifically, the comparison full-cell profile S can be generated according to the voltage difference per capacity (specifically, OCV difference) for the reference positive electrode profile Rp and the reference negative electrode profile Rn. For example, it is assumed that the voltage of the reference positive electrode profile Rp corresponding to a certain capacity x is $V_p$, and the voltage of the reference negative electrode profile Rn is $V_n$. The voltage $V_{pn}(x)$ of the comparison full-cell profile S corresponding to the capacity value x can be calculated as the voltage difference $V_{pn}(x) = V_p(x) - V_n(x)$. The profile correcting unit 120 may generate a comparison full-cell profile S by calculating the voltage difference $V_{pn}(x)$ between the reference positive electrode profile Rp and the reference negative electrode profile Rn for the entire range of values x of the capacity, i.e. $S(x) = V_{pn}(x) = V_p(x) - V_n(x): \forall x$.

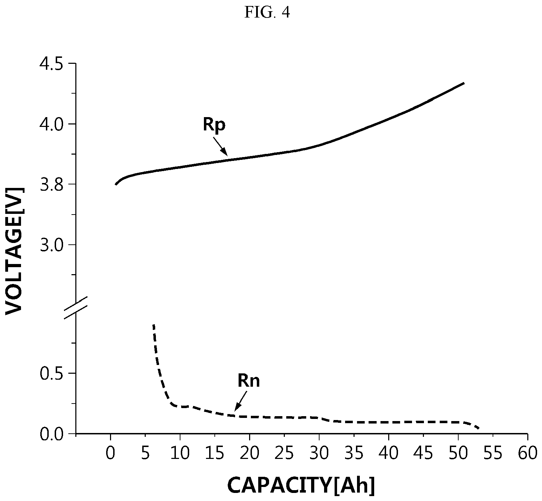

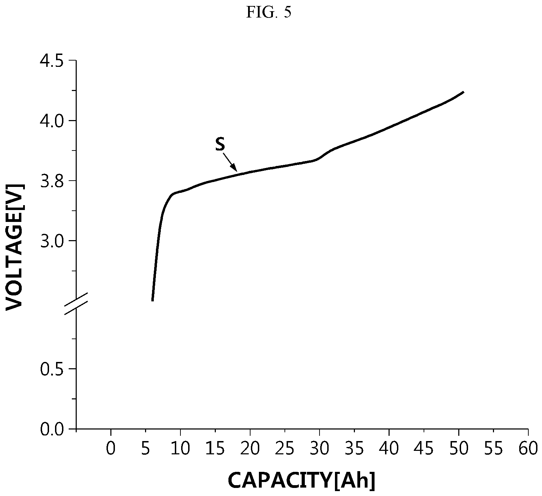

FIG. 4 is a diagram schematically showing a reference positive electrode profile Rp and a reference negative electrode profile Rn according to an embodiment of the present disclosure. FIG. 5 is a diagram schematically showing a comparison full-cell profile S according to an embodiment of the present disclosure. In the embodiment of FIGS. 4 and 5, the comparison full-cell profile S can be generated based on the voltage difference per capacity between the reference positive electrode profile Rp and the reference negative electrode profile Rn.

The profile correcting unit 120 may be configured to generate an adjusted positive electrode profile and an adjusted negative electrode profile by adjusting the reference positive electrode profile Rp and the reference negative electrode profile Rn until the generated comparison full-cell profile S corresponds to the OCV profile Rocv.

Specifically, the profile correcting unit 120 may calculate an error between the comparison full-cell profile S and the OCV profile Rocv. Additionally, the profile correcting unit 120 may adjust the reference positive electrode profile Rp and the reference negative electrode profile Rn until the error between the comparison full-cell profile S and the OCV profile Rocv is minimized. If the comparison full-cell profile S that minimizes the error with the OCV profile Rocv is determined, the adjusted positive electrode profile and the adjusted negative electrode profile, which are the basis of the determined comparison full-cell profile S, may be estimated as the positive electrode profile and the negative electrode profile that represent the current state of the battery. With current technology, there is a problem that it is not possible to directly obtain the positive electrode profile and the negative electrode profile indicating the current state of the battery without directly disassembling the battery. Therefore, it can be strongly assumed that the adjusted positive electrode profile and the adjusted negative electrode profile, which are the basis of the comparison full-cell profile S determined through the adjustment process, are the positive electrode profile and the negative electrode profile that reflect the current state of the battery.

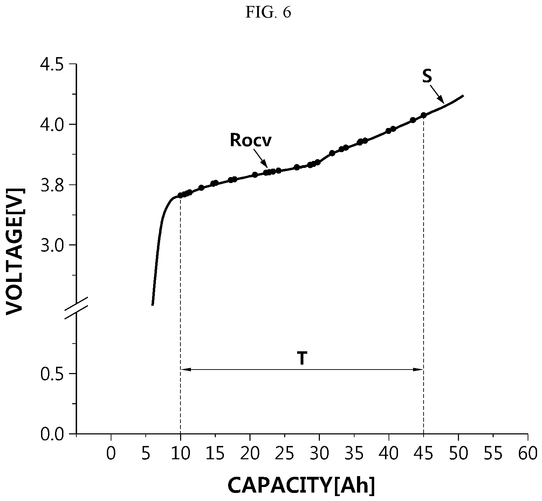

FIG. 6 is a diagram schematically showing a comparison full-cell profile S and an OCV profile Rocv according to an embodiment of the present disclosure. In the embodiment of FIG. 6, the profile correcting unit 120 can calculate an error between the two profiles based on the voltage difference per capacity of the comparison full-cell profile S and the OCV profile Rocv. Also, the profile correcting unit 120 can determine the comparison full-cell profile S in which the calculated error is minimized.

Preferably, the profile correcting unit 120 may be configured to determine a target capacity range T corresponding to the OCV profile Rocv.

For example, in the embodiment of FIG. 6, since the plurality of OCVs included in the OCV profile Rocv are measured aperiodically, the correspondence relationship between OCV and capacity may appear only in the target capacity range T. In other words, the target capacity range T is a capacity range of the OCV profile Rocv. Therefore, the profile correcting unit 120 can first determine the target capacity range T based on the OCV profile Rocv. For example, in the embodiment of FIG. 6, the target capacity range T may be determined to be a capacity range of 10 [Ah] or more and 45 [Ah] or less. The target capacity range T used by the profile correcting unit 120 may be the same as or different from the (minimum) range of capacity values for which OCV measurements are performed.

The profile correcting unit 120 can be configured to compare the comparison full-cell profile S and the OCV profile Rocv in the target capacity range T.

Specifically, since the comparison full-cell profile S is generated based on the reference positive electrode profile Rp and the reference negative electrode profile Rn, it can represent the correspondence relationship between voltage and capacity for the entire capacity range. In contrast, the OCV profile Rocv represents the correspondence relationship between OCV and capacity for the target capacity range T. Therefore, the profile correcting unit 120 can compare the two profiles only for the target capacity range T, which is the common capacity range of the comparison full-cell profile S and the OCV profile Rocv.

For example, in the embodiment of FIG. 6, the profile correcting unit 120 may compare the full-cell profile S and the OCV profile Rocv in the target capacity range T. Additionally, the profile correcting unit 120 can further adjust the reference positive electrode profile Rp and the reference negative electrode profile Rn according to the comparison results.

Below, diagnosis factors that the control unit 130 can select from the adjusted positive electrode profile and/or the adjusted negative electrode profile will be described in detail.

The control unit 130 may be configured to extract at least one of a positive electrode factor based on the adjusted positive electrode profile and a negative electrode factor based on the adjusted negative electrode profile as a diagnosis factor.

Here, the adjusted positive electrode profile is the result of adjusting the reference positive electrode profile Rp, and the adjusted negative electrode profile is the result of adjusting the reference negative electrode profile Rn. Specifically, as described above, the profile correcting unit 120 may adjust the reference positive electrode profile Rp and the reference negative electrode profile Rn so that the comparison full-cell profile S corresponds to the OCV profile Rocv.

In one example, the positive electrode factor may include, may be based on or may be a function of at least one of the positive electrode participation initiating point pi and the positive electrode participation finalizing point pf of the battery based on the adjusted positive electrode profile. In another example, the positive electrode factor may include may be based on or may be a function of at least one of the positive electrode participation initiating point pi, the positive electrode participation finalizing point pf and the positive electrode change rate ps of the battery based on the adjusted positive electrode profile.

The positive electrode participation initiating point pi may be a point corresponding to the starting capacity (lower limit capacity) of the target capacity range T in the adjusted positive electrode profile. For example, in the embodiment of FIG. 6, the starting capacity of the target capacity range T is 10 (Ah), so the point where the capacity value is 10 (Ah) in the adjusted positive electrode profile may be the positive electrode participation initiating point pi. Additionally, the value of the positive electrode participation initiating point pi may be a potential value or a SOC (State of Charge) value corresponding to the positive electrode participation initiating point pi in the adjusted positive electrode profile.

The positive electrode participation finalizing point pf may be a point corresponding to the ending capacity (upper limit capacity) of the target capacity range T in the adjusted positive electrode profile. For example, in the embodiment of FIG. 6, the ending capacity of the target capacity range T is 45 (Ah), so the point where the capacity value is 45 (Ah) in the adjusted positive electrode profile may be the positive electrode participation finalizing point pf. Also, the value of the positive electrode participation finalizing point pf may be a potential value or SOC value corresponding to the positive electrode participation finalizing point pf in the adjusted positive electrode profile.

The positive electrode change rate ps may mean the change rate [%] of the adjusted positive electrode profile with respect to the reference positive electrode profile Rp. Specifically, the positive electrode change rate ps may be a contraction ratio or expansion ratio of the adjusted positive electrode profile with respect to the positive negative electrode profile Rp. For example, if the adjusted positive electrode profile is a 10% contraction of from the reference positive electrode profile Rp, the positive electrode change rate ps is 90%. Conversely, if the adjusted positive electrode profile is a 10% extension of the reference positive electrode profile Rp, the positive electrode change rate ps is 110%.

The negative electrode factor may include, may be based on or may be a function of at least one of a negative electrode participation initiating point ni, a negative electrode participation finalizing point nf, and a negative electrode change rate ns of the battery based on the adjusted negative electrode profile.

The negative electrode participation initiating point ni may be a point corresponding to the starting capacity (lower limit capacity) of the target capacity range T in the adjusted negative electrode profile. For example, in the embodiment of FIG. 6, the starting capacity of the target capacity range T is 10 (Ah), so the point where the capacity value is 10 (Ah) in the adjusted negative electrode profile may be the negative electrode participation initiating point ni. Also, the value of the negative electrode participation initiating point ni may be a potential value or SOC value corresponding to the negative electrode participation initiating point ni in the adjusted negative electrode profile.

The negative electrode participation finalizing point nf may be a point corresponding to the ending capacity (upper limit capacity) of the target capacity range T in the adjusted negative electrode profile. For example, in the embodiment of FIG. 6, the final capacity of the target capacity range T is 45 (Ah), so the point where the capacity value is 45 (Ah) in the adjusted negative electrode profile may be the negative electrode participation finalizing point nf. Also, the value of the negative electrode participation finalizing point nf may be a potential value or SOC value corresponding to the negative electrode participation finalizing point nf in the adjusted negative electrode profile.

The negative electrode change rate ns may mean the change rate [%] of the adjusted negative electrode profile with respect to the reference negative electrode profile Rn. Specifically, the negative electrode change rate ns may be a contraction ratio or expansion ratio of the adjusted negative electrode profile with respect to the reference negative electrode profile Rn. For example, if the adjusted negative electrode profile is a 10% contraction of from the reference negative electrode profile Rn, the negative electrode change rate ns is 90%. Conversely, if the adjusted negative electrode profile is a 10% extension of the reference negative electrode profile Rn, the negative electrode change rate ns is 110%.

The control unit 130 may be configured to estimate the state of at least one of the positive electrode and the negative electrode of the battery, the available lithium of the battery, and the state of the remaining capacity the battery depending on the type of diagnosis factor. For example, the control unit 130 may be configured to estimate at least one of positive electrode SOH, negative electrode SOH, available lithium SOH, and capacity SOH for the battery depending on the type of diagnosis factor. Hereinafter, it will be explained that the values of the positive electrode participation initiating point pi and the positive electrode participation finalizing point pf refer to the corresponding SOCs in the adjusted positive electrode profile, and the values of the negative electrode participation initiating point ni and the negative electrode participation finalizing point nf refer to the corresponding SOCs in the adjusted negative electrode profile.

*Positive Electrode SOH - SOH$_P$*

The positive electrode SOH indicates the degree of deterioration of the positive electrode of the battery. In other words, the positive electrode SOH is an indicator of the degree to which the positive electrode of the battery has deteriorated. As the battery deteriorates, the positive electrode reaction area decreases due to side reactions, etc., so the positive electrode capacity participating in the reaction may decrease. Accordingly, the control unit 130 can estimate the degree of deterioration for positive electrode capacity loss by calculating the positive electrode SOH.

In one example, when the control unit 130 extracts the positive electrode participation finalizing point pf as a diagnosis factor, the positive electrode SOH can be calculated using one of Equations 1 to 3 below.

[Equation 1]

$$SOH\_P = \frac{pf}{R\_pf} \times 100$$

Here, SOH_P is the positive electrode SOH, pf is the value of the positive electrode participation finalizing point corresponding to the battery in the current state, and R_pf is the value of the positive electrode participation finalizing point corresponding to the battery in the BOL state.

Specifically, pf is the value of the positive electrode participation finalizing point corresponding to the ending capacity of the target capacity range T in the adjusted negative electrode profile corresponding to the OCV profile Rocv for the battery in the current state. R_pf is the value of the positive electrode participation finalizing point corresponding to the ending capacity of the target capacity range T in the adjusted negative electrode profile corresponding to the OCV profile Rocv for the battery in BOL state. In other words, R_pf is a reference value preset to correspond to the value of the positive electrode participation finalizing point pf corresponding to the battery in the current state. the control unit 130 can estimate a positive electrode SOH (SOH_P) by calculating the ratio of the value of the positive electrode participation finalizing point pf to the reference value (R_pf). For example, if the reference value (R_pf) is 85.1% and the value of the positive electrode participation finalizing point pf is 84.6%, the control unit 130 may estimate the positive electrode SOH (SOH_P) as 99.4% by calculating the formula "84.6÷85.1 × 100".

[Equation 2]

$$SOH_P = \frac{pf_{MOL} - pi_{BOL}}{pf_{BOL} - pi_{BOL}}$$

Here, $SOH_P$ is the positive electrode SOH, $pf_{MOL}$ is the value of the positive electrode participation finalizing point corresponding to the battery in the current state (MOL), $pf_{BOL}$ is the value of the positive electrode participation finalizing point corresponding to the battery in the BOL state, and $pi_{BOL}$ is the value of the positive electrode participation initiating point corresponding to the battery in the BOL state. Here, $pf_{BOL}$, $pi_{BOL}$, and $pf_{MOL}$ may be SOC values corresponding to the corresponding point.

[Equation 3]

$$SOH_P = \frac{pf_{MOL} - pi_{BOL}}{nf_{BOL} - ni_{BOL}}$$

Here, $nf_{BOL}$ is the value of the negative electrode participation finalizing point corresponding to the battery in the BOL state, and $ni_{BOL}$ is the value of the negative electrode participation initiating point corresponding to the battery in the BOL state. Here, $ni_{BOL}$ and $nf_{MOL}$ may be SOC values corresponding to the corresponding point.
In another example, when the control unit 130 may extract the positive electrode change rate ps as a diagnostic factor, the control unit 130 may calculate the positive electrode SOH using Equation 4 below.

[Equation 4]

$$SOH_P = \frac{ps_{MOL}}{ps_{BOL}}$$

Here, $ps_{BOL}$ is the positive electrode change rate corresponding to the battery in the BOL state, and $ps_{MOL}$ is the positive electrode change rate corresponding to the battery in the current state. Specifically, $ps_{BOL}$ refers to the change rate of the reference positive electrode profile Rp with respect to the initial positive electrode profile. Here, if the initial positive electrode profile and the reference positive electrode profile Rp are the same, $ps_{BOL}$ may be 1 or 100%. Hereinafter, for convenience of explanation, the initial positive electrode profile and the reference positive electrode profile Rp are described as being the same. Also, $ps_{MOL}$ means the change rate of the adjusted positive electrode profile with respect to the reference positive electrode profile Rp.

*Negative Electrode SOH - SOH_N*

The negative electrode SOH indicates the degree of deterioration of the negative electrode of the battery. In other words, the negative electrode SOH is an indicator of the degree to which the negative electrode of the battery has deteriorated. As with the loss of the positive electrode capacity, as the battery deteriorates, the negative electrode reaction area decreases due to side reactions, etc., so the negative electrode capacity participating in the reaction may decrease. Accordingly, the control unit 130 can estimate the degree of deterioration for the negative electrode capacity loss by calculating the negative electrode SOH.
In one example, when the control unit 130 extracts the negative electrode change rate as a diagnosis factor, the negative electrode SOH can be calculated using one of Equations 5 to 7 below.

[Equation 5]

$$SOH\_N = \frac{ns}{R\_ns} \times 100$$

Here, SOH_N is the negative electrode SOH, ns is the negative electrode change rate corresponding to the battery in the current state, and R_ns is the negative electrode change rate corresponding to the battery in the BOL state.

Specifically, ns is the ratio of the change in the adjusted negative electrode profile corresponding to the OCV profile Rocv for the battery in the current state compared to the reference negative electrode profile Rn. R_ns is the ratio of the change in the adjusted negative electrode profile corresponding to the OCV profile Rocv for the battery in the BOL state compared to the reference negative electrode profile Rn. Here, R_ns is a reference value preset to correspond to the negative electrode change rate corresponding to the battery in the current state.

The control unit 130 can estimate the negative electrode SOH (SOH_N) by calculating the ratio of the negative electrode change rate ns to the reference value (R_ns). For example, if the reference value (R_ns) is 104.7% and the negative electrode change rate ns is 97.7%, the control unit 130 may estimate the negative electrode SOH (SOH_N) as 93.3% by calculating the formula "$97.7 \div 104.7 \times 100$".

[Equation 6]

$$SOH_N = \frac{nf_{MOL} - ni_{BOL}}{nf_{BOL} - ni_{BOL}}$$

Here, $SOH_N$ is the negative electrode SOH, $nf_{MOL}$ is the value of the negative electrode participation finalizing point corresponding to the battery in the current state (MOL), $nf_{BOL}$ is the value of the negative electrode participation finalizing point corresponding to the battery in the BOL state, and $ni_{BOL}$ is the value of the negative electrode participation initiating point corresponding to the battery in the BOL state. Here, $nf_{BOL}$, $ni_{BOL}$, and $nf_{MOL}$ may be SOC values corresponding to the corresponding point.

[Equation 7]

$$SOH_N = \frac{nf_{MOL} - ni_{BOL}}{pf_{BOL} - pi_{BOL}}$$

Here, $pf_{BOL}$ is the value of the positive electrode participation finalizing point corresponding to the battery in the BOL state, and $pi_{BOL}$ is the value of the positive electrode participation initiating point corresponding to the battery in the BOL state. Here, $ni_{BOL}$ and $nf_{MOL}$ may be SOC values corresponding to the corresponding point.

In another example, when the control unit 130 extracts the diagnostic factor, the control unit 130 may calculate the positive electrode SOH using Equation 8 below.

[Equation 8]

$$SOH_N = \frac{ns_{MOL}}{ns_{BOL}}$$

Here, $SOH_N$ is the negative electrode SOH, $ns_{BOL}$ is the negative electrode change rate corresponding to the battery in the BOL state, and $ns_{MOL}$ is the negative electrode change rate corresponding to the battery in the current state. Specifically, $ns_{BOL}$ refers to the change rate of the reference negative electrode profile Rn with respect to the initial negative electrode profile. Here, if the initial negative electrode profile and the reference negative electrode profile Rn are the same, $ns_{BOL}$ may be 1 or 100%. Hereinafter, for convenience of explanation, the initial negative electrode profile and the reference negative electrode profile Rn are described as being the same. Also, $ns_{MOL}$ means the change rate of the adjusted negative electrode profile with respect to the reference negative electrode profile Rn.

*Available Lithium SOH - SOH_Li*

The available lithium SOH indicates the degree of degradation of available lithium in the battery. In other words, the available lithium SOH is an indicator of the degree of degradation of lithium ions participating in the reaction. When lithium plating (Li-plating) occurs, lithium metal may precipitate on the surface of the negative electrode. As the lithium plating phenomenon progresses, the amount of lithium metal precipitated increases, so the number of lithium ions participating in the reaction may decrease. Therefore, the control unit 130 can estimate the degree of degradation relative to the number of lithium ions participating in the reaction compared to the initial reaction by calculating the available lithium SOH.

In one example, when the control unit 130 extracts the positive electrode participation finalizing point pf and the positive electrode participation initiating point pi as diagnosis factors, the available lithium SOH can be calculated using Equation 9 below.

[Equation 9]

$$SOH\_Li = \frac{pf - pi}{R\_pf - R\_pi} \times 100$$

Here, SOH_Li is the available lithium SOH, pf is the value of the positive electrode participation finalizing point corresponding to the battery in the current state, and R_pf is the value of the positive electrode participation finalizing point corresponding to the battery in the BOL state. pi is the value of the positive electrode participation initiating point corresponding to the battery in the current state, and R_pi is the value of the positive electrode participation initiating point corresponding to the battery in the BOL state.

Specifically, pi is the value of the positive electrode participation initiating point corresponding to the starting capacity of the target capacity range T in the adjusted negative electrode profile corresponding to the OCV profile Rocv for the battery in the current state. R_pi is the value of the positive electrode participation initiating point corresponding to the starting capacity of the target capacity range T in the adjusted negative electrode profile corresponding to the OCV profile Rocv for the battery in the BOL state. In other words, R_pi is a reference value preset to correspond to the value of the positive electrode participation initiating point pi corresponding to the battery in the current state.

The control unit 130 may calculate a first difference between reference values (R_pi, R_pf). Additionally, the control unit 130 may calculate a second difference between the value of the positive electrode participation initiating point pi and the value of the positive electrode participation finalizing point pf. Finally, the control unit 130 may estimate the available lithium SOH (SOH_Li) by calculating the ratio of the second difference to the first difference. For example, if the reference value (R_pi) is 7.7%, the reference value (R_pf) is 86.2%, the value of the positive electrode participation initiating point pi is 9.3%, and the value of the positive electrode participation finalizing point pf is 86.0%, the control unit 130 can estimate the available lithium SOH (SOH_Li) as 97.7% by calculating the formula "(86.0 - 9.3)÷(86.2 - 7.7) × 100".

In another example, when the control unit 130 extracts the positive electrode participation initiating point pi as diagnosis factors, the available lithium SOH can be calculated using Equation 10 or 11 below.

[Equation 10]

$$SOH_{Li} = \frac{pf_{BOL} - pi_{MOL}}{pf_{BOL} - pi_{BOL}}$$

[Equation 11]

$$SOH_{Li} = \frac{pf_{BOL} - pi_{MOL}}{nf_{BOL} - ni_{BOL}}$$

Here, SOH_{Li} is the available lithium SOH. $pi_{MOL}$ is the value of the positive electrode participation initiating point corresponding to the current state of the battery. Here, $pi_{MOL}$ may be the SOC value corresponding to the corresponding point.

*Capacity SOH - SOH$_Q$*

The capacity SOH indicates the degree of degradation of the battery capacity. In other words, the capacity SOH is an indicator of the degree of degradation of the current available capacity compared to the initial capacity of the battery. As the battery deteriorates, the available capacity of the battery may naturally decrease. Therefore, the control unit 130 can estimate the degree of degradation of the current capacity compared to the initial one by calculating the capacity SOH.

In one example, when the control unit 130 extracts the negative electrode participation finalizing point nf and the negative electrode participation initiating point ni as diagnosis factors, the capacity SOH can be calculated using Equation 12 below.

[Equation 12]

$$\text{SOH\_Q} = \frac{nf - ni}{R\_nf - R\_ni} \times 100$$

Here, SOH_Q is capacity SOH, nf is the value of the negative electrode participation finalizing point corresponding to the battery in the current state, and R_nf is the value of the negative electrode participation finalizing point corresponding to the battery in the BOL state. ni is the value of the negative electrode participation initiating point corresponding to the battery in the current state, and R_ni is the value of the negative electrode participation initiating point corresponding to the battery in the BOL state.

Specifically, ni is the value of the negative electrode participation initiating point corresponding to the starting capacity of the target capacity range T in the adjusted negative electrode profile corresponding to the OCV profile Rocv for the battery in the current state. R_ni is the value of the negative electrode participation initiating point corresponding to the starting capacity of the target capacity range T in the adjusted negative electrode profile corresponding to the OCV profile Rocv for the battery in the BOL state. In other words, R_ni is a reference value preset to correspond to the value of the negative electrode participation initiating point ni corresponding to the battery in the current state.

Specifically, nf is the value of the negative electrode participation finalizing point corresponding to the ending capacity of the target capacity range T in the adjusted negative electrode profile corresponding to the OCV profile Rocv for the battery in the current state. R_nf is the value of the negative electrode participation finalizing point corresponding to the ending capacity of the target capacity range T in the adjusted negative electrode profile corresponding to the OCV profile Rocv for the battery in the BOL state. In other words, R_nf is a reference value preset to correspond to the value of negative electrode participation finalizing point nf corresponding to the battery in the current state.

The control unit 130 may calculate the difference between the reference values (R_ni, R_nf). Additionally, the control unit 130 may calculate a second difference between the value of the negative electrode participation initiating point ni and the value of the negative electrode participation finalizing point nf. Finally, the control unit 130 may estimate the capacity SOH (SOH_Q) by calculating the ratio of the second difference to the first difference. For example, if the reference value (R_ni) is 0.4%, the reference value (R_nf) is 78.9%, the value of negative electrode participation initiating point ni is 0.2%, and the value of negative electrode participation finalizing point nf is 76.8%, the control unit 130 can estimate the capacity SOH (SOH_Q) as 97.6% by calculating the formula "(76.8 - 0.2)÷(78.9 - 0.4) × 100".

In another example, when the control unit 130 extracts the positive electrode participation finalizing point pf and the positive electrode participation initiating point pi as diagnosis factors, the capacity SOH can be calculated using one of Equations 13 and 14 below.

[Equation 13]

$$SOH_Q = \frac{pf_{MOL} - pi_{MOL}}{pf_{BOL} - pi_{BOL}}$$

[Equation 14]

$$SOH_Q = \frac{pf_{MOL} - pi_{MOL}}{nf_{BOL} - ni_{BOL}}$$

Here, $SOH_Q$ is capacity SOH. $pf_{BOL}$, $pi_{BOL}$, $pf_{MOL}$ and $pi_{MOL}$ are as described above. $nf_{MOL}$ is the value of the negative electrode participation finalizing point corresponding to the battery in the current state, and $ni_{MOL}$ is the value of the negative electrode participation initiating point corresponding to the battery in the current state.

In yet another example, when the control unit 130 extracts the negative electrode participation finalizing point nf and the negative electrode participation initiating point ni as diagnostic factors, the control unit 130 may calculate capacity SOH using one of Equations 15 and 16 below.

[Equation 15]

$$SOH_Q = \frac{nf_{MOL} - ni_{MOL}}{nf_{BOL} - ni_{BOL}}$$

[Equation 16]

$$SOH_Q = \frac{nf_{MOL} - ni_{MOL}}{pf_{BOL} - pi_{BOL}}$$

Here, $SOH_Q$ is capacity SOH, $nf_{MOL}$ is the value of the negative electrode participation finalizing point corresponding to the battery in the current state, and $ni_{MOL}$ is the value of the negative electrode participation initiating point corresponding to the battery in the current state. $nf_{BOL}$, $ni_{BOL}$, $pf_{BOL}$ and $pi_{BOL}$ are as described above.

Heretofore, examples have been described in which the control unit 130 may estimate one or more of the positive electrode SOH ($SOH_p$), the negative electrode SOH ($SOH_N$), the available lithium SOH ($SOH_{Li}$), and the capacity SOH ($SOH_Q$). However, the control unit 130 may calculate the 1 (or 100%) complement of the respective SOH to estimate the positive electrode degradation rate, the negative electrode degradation rate, the available lithium degradation rate, and the capacity degradation rate, respectively. For example, the control unit 130 may estimate the positive electrode degradation rate by calculating "1-positive electrode SOH".

The apparatus 100 according to an embodiment of the present disclosure can estimate the SOH of a battery from various aspects depending on the extracted diagnosis factor. For example, according to the extracted diagnosis factor, it is possible to estimate the positive electrode SOH, the negative electrode SOH, the available lithium SOH, and the capacity SOH, so the degree of battery degradation for each item can be specifically diagnosed.

The control unit 130 may be configured to adjust usage conditions for the battery based on the estimated SOH. For example, control unit 130 may be configured to adjust usage conditions for the battery based on at least one or more of the positive electrode SOH, the negative electrode SOH, the available lithium SOH, and the capacity SOH.

Specifically, the control unit 130 may adjust the available SOC range for the battery based on the estimated SOH(s). For example, the control unit 130 may reduce the upper limit of the available SOC range for the battery. As another example, the control unit 130 may increase the lower limit of the available SOC range for the battery. As another example, the control unit 130 may decrease the upper limit of the available SOC range for the battery and increase the lower limit of the available SOC range.

Through adjustment of the available SOC range, loss of positive electrode response area and negative electrode response area can be prevented. Additionally, because loss of available lithium is prevented, lithium metal can be prevented from precipitating. Additionally, the generation of gas inside the battery can be suppressed.

Hereinafter, with reference to FIGS. 7 to 14, an embodiment in which the profile correcting unit 120 adjusts the reference positive electrode profile Rp and the reference negative electrode profile Rn will be described in more detail.

FIGS. 7 to 14 are diagrams for explaining the process of adjusting a reference positive electrode profile Rp and a reference negative electrode profile Rn according to an embodiment of the present disclosure.

FIG. 7 is a graph referenced to for explaining an example of the reference positive electrode profile Rp and the reference negative electrode profile Rn, respectively. In the graph of FIG. 7, the horizontal axis (X-axis) represents capacity (Ah) and the vertical axis (Y-axis) represents voltage (V).

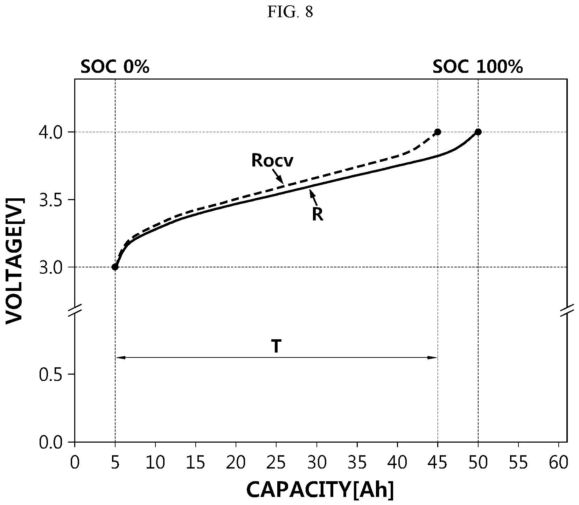

FIG. 8 is a graph referenced to for explaining an example of the OCV profile Rocv of the target battery. In the graph of FIG. 8, the horizontal axis (X-axis) represents capacity (Ah) and the vertical axis (Y-axis) represents voltage (V). Referring to FIG. 8, it is assumed that the target capacity range T is a capacity range of 5 (Ah) to 45 (Ah).

The profile correcting unit 120 may be configured to compare the OCV profile Rocv and at least one comparison full-cell profile S. Here, the comparison full-cell profile S may be the result of synthesizing (combining) the adjusted positive electrode profile and the adjusted negative electrode profile based on the reference positive electrode profile Rp and the reference negative electrode profile Rn, respectively, stored in the storage unit 140.

In other words, when the reference full-cell profile R is the result of subtracting a part of the reference negative electrode profile Rn from a part of the reference positive electrode profile Rp, the comparison full-cell profile S can be said to be the result of subtracting a part of the adjusted negative electrode profile from a part of the adjusted positive electrode profile.

The profile correcting unit 120 may generate at least one comparison full-cell profile S by directly adjusting the reference positive electrode profile Rp and the reference negative electrode profile Rn. Alternatively, at least one comparison full-cell profile S may be secured in advance based on the reference positive electrode profile Rp and the reference negative electrode profile Rn and stored in the storage unit 140. In this case, the profile correcting unit 120 may obtain the comparison full-cell profile S in the form of accessing the storage unit 140 and reading the comparison full-cell profile S.

The profile correcting unit 120 may generate a plurality of comparison full-cell profile Ss from the reference positive electrode profile Rp and the reference negative electrode profile Rn by repeating the process of adjusting each of the reference positive electrode profile Rp and the reference negative electrode profile Rn to various levels and then synthesizing them. The comparison full-cell profile S can also be called an 'adjusted reference full-cell profile'.

The profile correcting unit 120 may specify any one comparison full-cell profile S that has a minimum error with the OCV profile Rocv among the plurality of comparison full-cell profile Ss.

Next, the profile correcting unit 120 may determine that the adjusted positive electrode profile and the adjusted negative electrode profile mapped to the specified comparison full-cell profile S are the positive electrode profile and the negative electrode profile of the battery. In the following, it should be noted that the positive electrode profile is a finally determined adjusted positive electrode profile, and the negative electrode profile is a finally determined adjusted negative electrode profile.

In relation to this, various methods known at the filing time of the present disclosure can be employed to determine the error between two profiles, each of which can be expressed in a two-dimensional coordinate system. For example, the integral value of the absolute value of the area between two profiles or RMSE (Root Mean Square Error) can be used as the error between two profiles.

According to this configuration of the present disclosure, various state information about the battery can be obtained based on the finally determined positive electrode profile and negative electrode profile. The finally determined positive electrode profile and negative electrode profile may be mapped to the comparison full-cell profile S mapped to the minimum error. In particular, it can be said that the comparison full-cell profile S based on the finally determined positive electrode profile and negative electrode profile is almost identical to OCV profile Rocv in terms of shape.

Therefore, according to the present disclosure, the positive electrode profile and the negative electrode profile of the battery can be obtained even without disassembling the battery.

If the battery is a new battery, the positive electrode profile and the negative electrode profile of the battery can be analyzed to more easily diagnose whether a defect has occurred in the battery and, if so, what type of defect it is.

If the battery is being used after it has been verified to be a good product, it is possible to determine the extent to which the battery has deteriorated for each deterioration item through the positive electrode profile and the negative electrode profile of the battery.

Moreover, according to an embodiment of the present disclosure, the positive electrode profile and the negative electrode profile of the battery can be obtained in a simple manner. Even if only one reference positive electrode profile Rp and one reference negative electrode profile Rn are stored in the storage unit 140, the present disclosure may be implemented. That is, there is no need to store a plurality of reference positive electrode profiles Rp and/or a plurality of reference negative electrode profiles Rn in the storage unit 140. Accordingly, the storage capacity of the storage unit 140 does not need to be high, and there is no need to conduct numerous preliminary tests required to secure a plurality of reference positive electrode profiles Rp and/or a plurality of reference negative electrode profiles Rn.

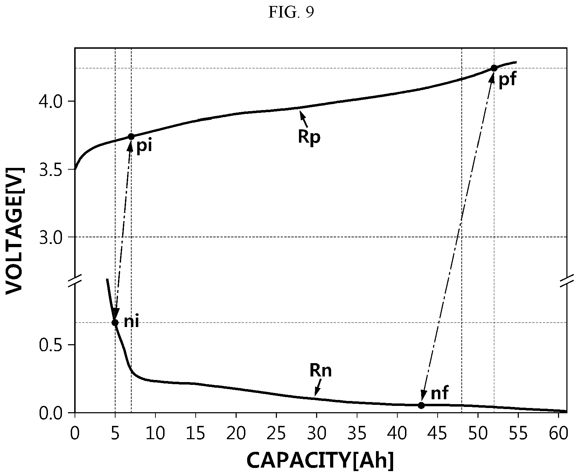

FIGS. 9 to 11 are diagrams referenced to for explaining an example of a procedure for generating a comparison full-cell profile S used for comparison with the OCV profile Rocv according to an embodiment of the present disclosure.

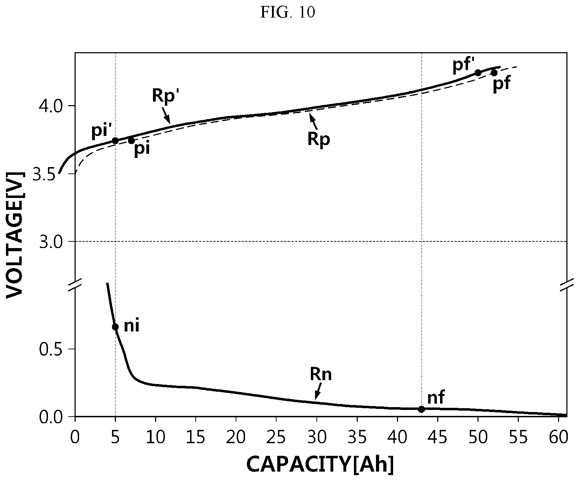

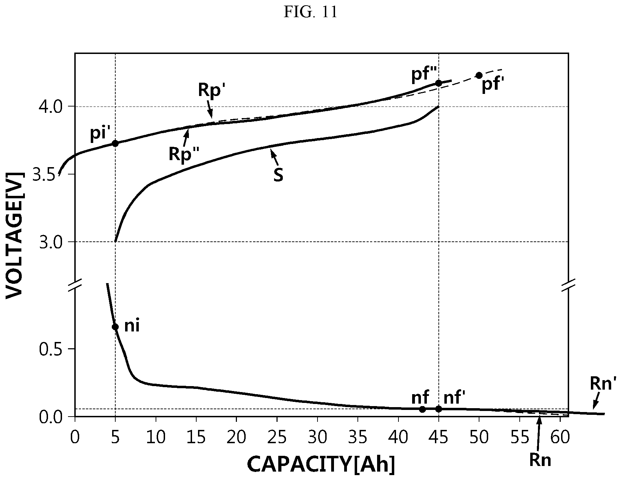

The procedure for generating a comparison full-cell profile S, which will be described with reference to FIGS. 9 to 11, proceeds in the following order: a first routine that sets four points (positive electrode participation initiating point, positive electrode participation finalizing point, negative electrode participation initiating point, negative electrode participation finalizing point) to correspond to the voltage range of interest (see FIG. 9), a second routine that performs profile shifting (see FIG. 10), and a third routine that performs capacity scaling (see FIG. 11). That is, the procedure for generating a comparison full-cell profile S according to an embodiment of the present disclosure includes the first to third routines.

First, referring to FIG. 9, the reference positive electrode profile Rp and the reference negative electrode profile Rn are the same as those shown in FIG. 7.

The profile correcting unit 120 determines a positive electrode participation initiating point pi, a positive electrode participation finalizing point pf, a negative electrode participation initiating point ni, and a negative electrode participation finalizing point nf on the reference positive electrode profile Rp and the reference negative electrode profile Rn.

Either the positive electrode participation initiating point pi or the negative electrode participation initiating point ni depends on the other.

As an example, the profile correcting unit 120 divides the positive electrode voltage range from the starting point of the reference positive electrode profile Rp to the end point (or second setting voltage) into a plurality of micro voltage sections, and then set the boundary point of two adjacent micro voltage sections among the plurality of micro voltage sections as the positive electrode participation initiating point pi. Each micro voltage section may have a predetermined size (e.g., 0.01 V). Next, the profile correcting unit 120 may set a point on the reference negative electrode profile Rn, which is smaller than the positive electrode participation initiating point pi by the first setting voltage (e.g., 3 V), as the negative electrode participation initiating point ni.

As another example, the profile correcting unit 120 may divide the negative electrode voltage range from the start point to the end point of the reference negative electrode profile Rn into a plurality of micro voltage sections of a predetermined size, and then set the boundary point of two adjacent micro voltage sections among the plurality of micro voltage sections as the negative electrode participation initiating point ni. Next, the profile correcting unit 120 may search for a point, which is greater than the negative electrode participation initiating point ni by the first setting voltage, from the reference positive electrode profile Rp and set the searched point as the positive electrode participation initiating point pi.

Either the positive electrode participation finalizing point pf and the negative electrode participation finalizing point nf depends on the other.

As an example, the profile correcting unit 120 may divide the voltage range from the second setting voltage to the end point of the reference positive electrode profile Rp into a plurality of micro voltage sections of a predetermined size, and then set the boundary point of two adjacent micro voltage sections among the plurality of micro voltage sections as the positive electrode participation finalizing point pf. Next, the profile correcting unit 120 may set a point on the reference negative electrode profile Rn, which is smaller than the positive electrode participation finalizing point pf by a second setting voltage (e.g., 4 V), as the negative electrode participation finalizing point nf.

As another example, the profile correcting unit 120 may divide the negative electrode voltage range from the start point to the end point of the reference negative electrode profile Rn into a plurality of micro voltage sections of a predetermined size, and then set the boundary point of two adjacent micro voltage sections among the plurality of micro voltage sections as the negative electrode participation finalizing point nf. Next, the profile correcting unit 120 may search for a point, which is greater than the negative electrode participation finalizing point nf by a second setting voltage, from the reference positive electrode profile Rp and set the searched point as the positive electrode participation finalizing point pf.

If the determination of the positive electrode participation initiating point pi, the positive electrode participation finalizing point pf, the negative electrode participation initiating point ni, and the negative electrode participation finalizing point nf is completed, the profile correcting unit 120 shifts at least one of the reference positive electrode profile Rp and the reference negative electrode profile Rn to the left or right along the horizontal axis.

Referring to FIG. 10, the profile correcting unit 120 may shift the reference positive electrode profile Rp and/or the reference negative electrode profile Rn so that the capacity values of the positive electrode participation initiating point pi and the negative electrode participation initiating point ni match.

Alternatively, the profile correcting unit 120 may shift the reference positive electrode profile Rp and/or the reference negative electrode profile Rn so that the voltages of the positive electrode participation finalizing point pf and the negative electrode participation finalizing point nf match.

FIG. 10 shows the situation that the adjusted reference positive electrode profile Rp' is generated by shifting only the reference positive electrode profile Rp to the left, and as a result, the voltage of the positive electrode participation initiating point pi' matches the voltage of the negative electrode participation initiating point ni. The adjusted reference positive electrode profile Rp' is the result of applying an adjustment procedure of shifting to the left by the voltage difference between the positive electrode participation initiating point pi and the negative electrode participation initiating point ni to the reference positive electrode profile Rp. Therefore, the two points pi, pi' differ only in capacity value and have the same voltage. The two points pf, pf differ only in capacity value and have the same voltage.

When the adjustment result profiles Rp', Rn in which at least one of the reference positive electrode profile Rp and the reference negative electrode profile Rn is shifted are secured, the profile correcting unit 120 scales the capacity range of at least one of the adjustment result profiles Rp', Rn.

According to the example shown in FIG. 10, the profile correcting unit 120 performs an additional adjustment procedure to shrink or expand at least one of the adjusted reference positive electrode profile Rp' and the adjusted reference negative electrode profile Rn along the horizontal axis.

Referring to FIG. 11, the profile correcting unit 120 may generate an adjusted reference positive electrode profile Rp" by shrinking or expanding the adjusted reference positive electrode profile Rp' so that the size of the capacity range between the two points pi', pf of the adjusted reference positive electrode profile Rp' matches the size of the target capacity range T of the OCV profile Rocv. At this time, any one of the two points pi', pf can be fixed. Accordingly, the capacity difference between the two points pi', pf" of the adjusted reference positive electrode profile Rp" can be matched to the target capacity range T of the OCV profile Rocv.

In addition, the profile correcting unit 120 may generate an adjusted reference negative electrode profile Rn' by shrinking or expanding the reference negative electrode profile Rn so that the size of the capacity range between two points ni, nf of the reference negative electrode profile Rn matches the size of the target capacity range T of the OCV profile Rocv. At this time, any one of the two points ni, nf can be fixed. Accordingly, the capacity difference between the two points ni, nf of the adjusted reference negative electrode profile Rn' can be matched to the target capacity range T of the OCV profile Rocv.

In FIG. 11, the adjusted reference positive electrode profile Rp" is the result of shrinkage of the adjusted reference positive electrode profile Rp' shown in FIG. 8, and the adjusted reference negative electrode profile Rn' is the result of expansion of the reference negative electrode profile Rn shown in FIG. 10.

The positive electrode participation finalizing point pf" on the adjusted reference positive electrode profile Rp" corresponds to the positive electrode participation finalizing point pf on the adjusted reference positive electrode profile Rp'. The negative electrode participation finalizing point nf on the adjusted reference negative electrode profile Rn' corresponds to the negative electrode participation finalizing point nf on the reference negative electrode profile Rn.

The capacity difference between the positive electrode participation initiating point pi' and the positive electrode participation finalizing point pf" of the adjusted reference positive electrode profile Rp" corresponds to the size of the target capacity range T of the OCV profile Rocv. Likewise, the capacity difference between the negative electrode participation initiating point ni and the negative electrode participation finalizing point nf of the adjusted reference negative electrode profile Rn' corresponds to the size of the target capacity range T of the OCV profile Rocv.

In addition, the capacity range by two points pi', pf" of the adjusted reference positive electrode profile Rp" matches the capacity range by two points ni, nf of the adjusted reference negative electrode profile Rn'. The profile correcting unit 120 may generate the comparison full-cell profile S by subtracting the profile between two points pi, pf of the adjusted reference positive electrode profile Rp" from the profile between two points ni, nf of the adjusted reference negative electrode profile Rn'.

The profile correcting unit 120 can calculate the error (profile error) between the comparison full-cell profile S and the OCV profile Rocv. When the error between the comparison full-cell profile S and the OCV profile Rocv is minimized, the adjusted reference positive electrode profile Rp" corresponding to the comparison full-cell profile S may be determined as the adjusted positive electrode profile, and the adjusted reference negative electrode profile Rn' may be determined as the adjusted negative electrode profile.

The profile correcting unit 120 may map at least two of the adjusted reference positive electrode profile Rp", the adjusted reference negative electrode profile Rn', the positive electrode participation initiating point pi', the positive electrode participation finalizing point pf", the negative electrode participation initiating point ni, the negative electrode participation finalizing point nf, the first scale factor, the second scale factor, the comparison full-cell profile S, and the profile error to each other and record in the storage unit 140. The first scale factor can represent the rate of the capacity difference between two points pi', pf" relative to the capacity difference between two points pi0, pf0. The second scale factor may represent the rate of the capacity difference between two points ni, nf relative to the capacity difference between two points ni0, nf0.

Here, the profile correcting unit 120 may calculate the positive electrode change rate ps of the adjusted reference positive electrode profile Rp" for the reference positive electrode profile Rp. Also, the profile correcting unit 120 may calculate the negative electrode change rate ns of the adjusted reference positive electrode profile Rp Rn' for the reference negative electrode profile Rn. For example, the profile correcting unit 120 may determine the first scale factor as the positive electrode change rate ps and determine the second scale factor as the negative electrode change rate ns.

Meanwhile, as described above, when the positive electrode voltage range of the reference positive electrode profile Rp is divided into a plurality of micro voltage sections, the boundary point of two adjacent micro voltage sections among the plurality of micro voltage sections may be set as the positive electrode participation initiating point pi.

For example, if the positive electrode voltage range of the reference positive electrode profile Rp is divided into one hundred small voltage ranges, there may be one hundred boundary points that can be set as the positive electrode participation initiating point pi. In addition, if the voltage range equal to or greater than the second setting voltage in the reference positive electrode profile Rp is divided into 40 small voltage ranges, there can be 40 boundary points that can be set as the positive electrode participation finalizing point pf. In this case, up to 4000 different comparison full-cell profile Ss can be generated.

Of course, it will be easy to understand by those skilled in the art that as the size of the micro voltage section decreases, the number of comparison full-cell profile Ss that can be maximally generated increases, and conversely, as the size of the micro voltage section increases, the number of comparison full-cell profile Ss that can be maximally generated decreases.

The profile correcting unit 120 may identify the minimum value among the profile errors of the plurality of comparison full-cell profile S generated as described above, and then obtain information mapped to the minimum profile error (e.g., at least one of the positive electrode participation initiating point pi, the positive electrode participation finalizing point pf, the negative electrode participation initiating point ni, the negative electrode participation finalizing point nf, the positive electrode change rate ps, and the negative electrode change rate ns) from the storage unit 140.

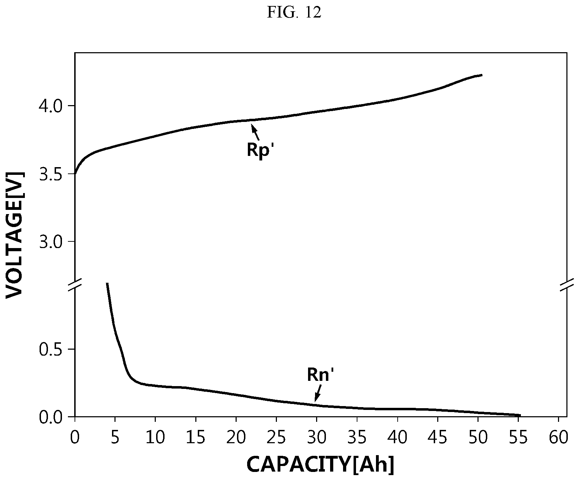

FIGS. 12 to 14 are diagrams referenced to for explaining another example of a procedure for generating a comparison full-cell profile S used for comparison with the OCV profile Rocv according to an embodiment of the present disclosure. For reference, the embodiments shown in FIGS. 12 to 14 are independent from the embodiments shown in FIGS. 9 to 11. Accordingly, terms or symbols commonly used in describing the embodiments shown in FIGS. 9 to 11 and the embodiments shown in FIGS. 12 to 14 should be understood as being limited to each embodiment.

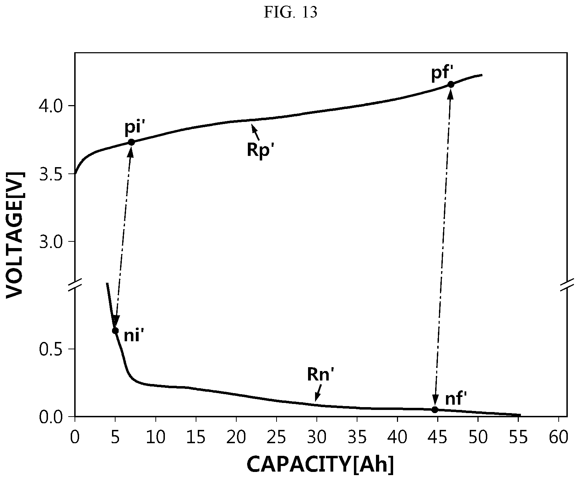

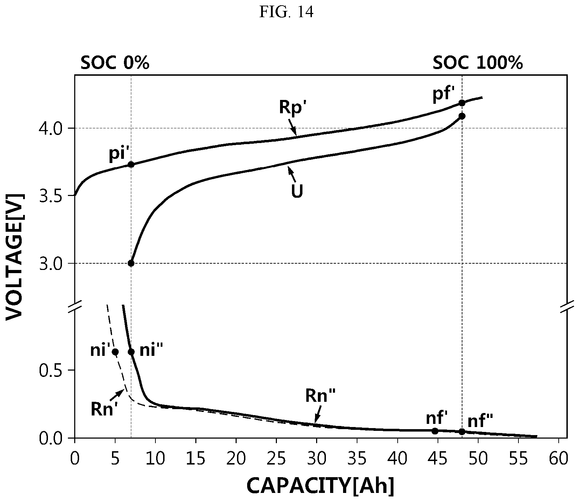

The generation procedure of the comparison full-cell profile S to be explained with reference to FIGS. 12 to 14 proceeds in the following order: a fourth routine for performing capacity scaling (see FIG. 12), a fifth routine of setting four points (the positive electrode participation initiating point, the positive electrode participation finalizing point, the negative electrode participation initiating point and the negative electrode participation finalizing point (see FIG. 13), and a sixth routine of performing profile shift (see FIG. 14). That is, the generation procedure of the comparison full-cell profile S according to another embodiment of the present disclosure includes the fourth to sixth routine.

Referring to FIG. 12, the reference positive electrode profile Rp and the reference negative electrode profile Rn are the same as those shown in FIG. 7.

The profile correcting unit 120 generates an adjusted reference positive electrode profile Rp' and an adjusted reference negative electrode profile Rn' by applying the first scale factor and the second scale factor selected from the scaling value range to the reference positive electrode profile Rp and the reference negative electrode profile Rn, respectively.

The scaling value range may be predetermined or may vary depending on the rate of the size of the target capacity range T of the OCV profile Rocv relative to the size of the capacity range of the reference full-cell profile R. As an example, assuming that the first scale factor and the second scale factor can be selected among the values spaced by 0.1% (i.e., 90%, 90.1%, 90.2%, ..., 98.9%, 99%) in the scaling numerical range (e.g., 90 to 99%), 91 values can be selected as the first scale factor and the second scale factor, respectively. In this case, up to 8,281 adjusted profile pairs can be generated to $91\times91=8,281$ adjustment levels (combination of first scale factor and second scale factor). The adjusted profile pair refers to a combination of the adjusted reference positive electrode profile Rp and the adjusted reference negative electrode profile Rn.

FIG. 12 shows an example in which the adjusted reference positive electrode profile Rp' and the adjusted reference negative electrode profile Rn' are the results of applying a first scale factor and a second scale factor less than 100% to the reference positive electrode profile Rp and the reference negative electrode profile Rn, respectively.

Since the first scale factor and the second scale factor are less than 100%, the adjusted reference positive electrode profile Rp' is the shrinkage of the reference positive electrode profile Rp along the horizontal axis, and the adjusted reference negative electrode profile Rn' is also the shrinkage of the reference negative electrode profile Rn along the horizontal axis. To facilitate understanding, the example is illustrated in the form where the starting point of each of the reference positive electrode profile Rp and the reference negative electrode profile Rn is fixed and the remaining portions are reduced to the left along the horizontal axis.

Referring to FIG. 13, the profile correcting unit 120 determines the positive electrode participation initiating point pi', the positive electrode participation finalizing point pf, the negative electrode participation initiating point ni' and the negative electrode participation finalizing point nf on the adjusted reference positive electrode profile Rp' and the adjusted reference negative electrode profile Rn'.

Either the positive electrode participation initiating point pi' or the negative electrode participation initiating point ni' may depend on the other. Additionally, either the positive electrode participation finalizing point pf or the negative electrode participation finalizing point nf may depend on the other. Additionally, either the positive electrode participation initiating point pi' or the positive electrode participation finalizing point pf may be set based on the other.

That is, if any one of the positive electrode participation initiating point pi', the positive electrode participation finalizing point pf, the negative electrode participation initiating point ni', and the negative electrode participation finalizing point nf is set, the remaining three points may be set automatically by the first setting voltage, the second setting voltage and/or the size of the target capacity range T of the OCV profile Rocv (e.g., charging capacity of SOC 0% to 100%).

As an example, the profile correcting unit 120 may divide the positive electrode voltage range from the start point of the adjusted reference positive electrode profile Rp' to the end point (or second setting voltage) into a plurality of micro voltage section, and then set the boundary point of two adjacent micro voltage sections among the plurality of micro voltage sections as the positive electrode participation initiating point pi'. Next, the profile correcting unit 120 may set the point on the adjusted reference negative electrode profile Rn, which is smaller than the positive electrode participation initiating point pi' by the first setting voltage (e.g., 3 V), as the negative electrode participation initiating point ni'.

As another example, the profile correcting unit 120 may divide the negative electrode voltage range from the start point to the end point of the adjusted reference negative electrode profile Rn' into a plurality of micro voltage sections of a predetermined size, and then set the boundary point of two adjacent voltage sections among the plurality of micro voltage sections as the negative electrode participation initiating point ni'. Next, the profile correcting unit 120 may search for a point, which is greater than the negative electrode participation initiating point ni' by the first setting voltage, from the reference positive electrode profile Rp and set the searched point as the positive electrode participation initiating point pi'.

As another example, the profile correcting unit 120 may divide the voltage range from the second setting voltage to the end point of the adjusted reference positive electrode profile Rp' into a plurality of micro voltage sections of a predetermined size, and then set the boundary point of the two micro voltage sections among the plurality of micro voltage sections as the positive electrode participation finalizing point pf. Next, the profile correcting unit 120 may search for a point, which is smaller than the positive electrode participation finalizing point pf by the second setting voltage (e.g., 4 V), in the adjusted reference negative electrode profile Rn', and set the searched point as the negative electrode participation finalizing point 'nf.

As another example, the profile correcting unit 120 may divide the negative electrode voltage range from the start point to the end point of the adjusted reference negative electrode profile Rn' into a plurality of micro voltage sections of a predetermined size, and then set the boundary point of two adjacent micro voltage sections among the plurality of micro voltage sections as the negative electrode participation finalizing point nf. Next, the profile correcting unit 120 may search for a point, which is greater than the negative electrode participation finalizing point nf by the second setting voltage, from the adjusted reference positive electrode profile Rp' and set the searched point as the positive electrode participation finalizing point pf.

If any one of the positive electrode participation initiating point pi', the positive electrode participation finalizing point pf, the negative electrode participation initiating point ni', and the negative electrode participation finalizing point nf is determined, the profile correcting unit 120 may additionally determine the remaining points based on the determined point.

As an example, if the positive electrode participation initiating point pi' is determined first, the profile correcting unit 120 may set the point on the adjusted reference positive electrode profile Rp', which has a capacity value that is larger than the capacity value of the positive electrode participation initiating point pi' by the size of the target capacity range T of the OCV profile Rocv, as the positive electrode participation finalizing point pf. Additionally, the profile correcting unit 120 may search for a point, which is lower than the positive electrode participation initiating point pi' by the first setting voltage, from the adjusted reference negative electrode profile Rn' and set the searched point as the negative electrode participation initiating point ni'. In addition, the profile correcting unit 120 may set a point on the adjusted reference negative electrode profile Rn', which has a capacity value larger than the capacity value of the negative electrode participation initiating point ni' by the size of the target capacity range T of the OCV profile Rocv, as the negative electrode participation finalizing point nf.

As another example, if the positive electrode participation finalizing point pf is determined first, the profile correcting unit 120 may set a point on the adjusted reference positive electrode profile Rp', which has a capacity value smaller than the capacity value of the positive electrode participation finalizing point pf by the size of the target capacity range T of the OCV profile Rocv, as the positive electrode participation initiating point pi'. Additionally, the profile correcting unit 120 may search for a point, which is lower than the positive electrode participation finalizing point pf by the second setting voltage, from the adjusted reference negative electrode profile Rn' and set the searched point as the negative electrode participation finalizing point nf. In addition, the profile correcting unit 120 may set a point on the adjusted reference negative electrode profile Rn', which has a capacity value smaller than the capacity value of the negative electrode participation finalizing point nf by the size of the target capacity range T of the OCV profile Rocv, as the negative electrode participation initiating point ni'.

As still another example, if the negative electrode participation initiating point ni' is determined, the profile correcting unit 120 may set a point on the reference negative electrode profile Rn', which has a capacity value larger than the capacity value of the negative electrode participation initiating point ni' by the size of the target capacity range T of the OCV profile Rocv, set as the negative electrode participation finalizing point nf. Additionally, the profile correcting unit 120 may search for a point, which is higher than the negative electrode participation initiating point ni' by the first setting voltage, from the adjusted reference positive electrode profile Rp' and set the searched point as the positive electrode participation initiating point pi'. In addition, the profile correcting unit 120 may set a point on the adjusted reference positive electrode profile Rp', which has a capacity value greater than the capacity value of the positive electrode participation initiating point pi' by the size of the target capacity range T of the OCV profile Rocv, as the positive electrode participation finalizing point pf.

As still another example, if the negative electrode participation finalizing point nf is determined, the profile correcting unit 120 may set a point on the reference negative electrode profile Rn', which has a capacity value smaller than the capacity value of the negative electrode participation finalizing point nf by the size of the target capacity range T of the OCV profile Rocv, as the negative electrode participation initiating point ni'. Additionally, the profile correcting unit 120 may search for a point, which is higher than the negative electrode participation finalizing point nf by the second setting voltage, from the adjusted reference positive electrode profile Rp' and set the searched point as the positive electrode participation finalizing point pf. In addition, the profile correcting unit 120 may set a point on the adjusted reference positive electrode profile Rp', which has a capacity value smaller than the capacity value of the positive electrode participation finalizing point pf by the size of the target capacity range T of the OCV profile Rocv, as the positive electrode participation initiating point pi'.

If the determination of the positive electrode participation initiating point pi', the positive electrode participation finalizing point pf, the negative electrode participation initiating point ni' and the negative electrode participation finalizing point nf is completed based on the pair of first scale factor and second scale factor, the profile correcting unit 120 may shift at least one of the adjusted reference positive electrode profile Rp' and the adjusted reference negative electrode profile Rn' along the horizontal axis so that the capacity values of the positive electrode participation initiating point pi' and the negative electrode participation initiating point ni' match or the capacity values of the positive electrode participation finalizing point pf and the negative electrode participation finalizing point nf match.

The adjusted reference negative electrode profile Rn" shown in FIG. 14 is obtained by shifting only the adjusted reference negative electrode profile Rn' shown in FIG. 13 to the right. Accordingly, the capacity values of the positive electrode participation initiating point pi' and the negative electrode participation initiating point ni" match each other. In this regard, since the capacity difference between the positive electrode participation initiating point pi' and the positive electrode participation finalizing point pf is the same as the capacity difference between the negative electrode participation initiating point ni' and the negative electrode participation finalizing point nf, if the capacity values of the positive electrode participation initiating point pi' and the negative electrode participation initiating point ni" match each other, the capacity values of the positive electrode participation finalizing point pf and the negative electrode participation finalizing point nf" also match each other.

Referring to FIG. 14, the profile correcting unit 120 may generate the comparison full-cell profile U by subtracting a partial profile between two points pi', pf of the adjusted reference positive electrode profile Rp' from the partial profile between into two points ni", nf" of the adjusted reference negative electrode profile Rn".

The profile correcting unit 120 may calculate the error (profile error) between the comparison full-cell profile U and the OCV profile Rocv. When the error between the comparison full-cell profile U and the OCV profile Rocv is minimized, the adjusted reference positive electrode profile Rp' corresponding to the comparison full-cell profile U may be determined as the adjusted positive electrode profile, and the adjusted reference negative electrode profile Rn" may be determined as the adjusted negative electrode profile.

The profile correcting unit 120 may map at least two of the adjusted reference positive electrode profile Rp', the adjusted reference negative electrode profile Rn", the positive electrode participation initiating point pi', the positive electrode participation finalizing point pf, the negative electrode participation initiating point ni", the negative electrode participation finalizing point nf', the positive electrode change rate ps, the negative electrode change rate ns, the comparison full-cell profile U, and the profile error with each other and record in the storage unit 140.

Here, the profile correcting unit 120 may calculate the positive electrode change rate ps of the adjusted reference positive electrode profile Rp' for the reference positive electrode profile Rp. Also, the profile correcting unit 120 may calculate the negative electrode change rate ns of the adjusted reference negative electrode profile Rn" for the reference negative electrode profile Rn. For example, the profile correcting unit 120 may determine the first scale factor as the positive electrode change rate ps and determine the second scale factor as the negative electrode change rate ns.

As described above, the profile correcting unit 120 may generate a comparison full-cell profile corresponding to each pair of first scale factor and second scale factor selected from the scaling value range. Since the pair of first scale factor and second scale factor is plural, it is obvious that the comparison full-cell profile will also be generated in plural. The profile correcting unit 120 may identify the minimum value among the profile errors of the plurality of comparison full-cell profiles and then obtain information mapped to the minimum profile error from the storage unit 140.

The apparatus 100 according to the present disclosure may be connected to a display device (not shown) and output information on the SOH of a battery. Because of this, the information about the SOH of the battery may be displayed on the display device.

The apparatus 100 according to the present disclosure may be connected to an alarm device (not shown) and output information on the SOH of a battery to operate the alarm device.

The apparatus 100 according to the present disclosure can be applied to the BMS. In other words, the BMS according to the present disclosure may include the above-described apparatus 100 for estimating a SOH. In this configuration, at least some of the components of the apparatus 100 may be implemented by supplementing or adding functions of components included in a conventional BMS. For example, the profile obtaining unit 110, the profile correcting unit 120, the control unit 130 and the storage unit 140 of the apparatus 100 may be implemented as components of a BMS. Additionally, the apparatus 100 according to the present disclosure may be provided in the battery pack. That is, the battery pack according to the present disclosure may include the above-described apparatus 100 for estimating a SOH and at least one battery cell. Additionally, the battery pack may further include electrical components (relays, fuses, etc.) and a case.

FIG. 15 is a diagram showing an exemplary configuration of the battery pack 1 including according to another embodiment of the present disclosure.

The positive electrode terminal of the battery 10 may be connected to the positive electrode terminal P+ of the battery pack 1, and the negative electrode terminal of the battery 10 may be connected to the negative electrode terminal P- of the battery pack 1.

The measuring unit 20 can be connected to the positive electrode terminal and the negative electrode terminal of the battery 10. Additionally, the measuring unit 20 can measure the voltage of the battery 10 by measuring the positive electrode potential and the negative electrode potential of the battery 10 and calculating the difference between the positive electrode potential and the negative electrode potential. Preferably, the measuring unit 20 can measure OCV of the battery 10.

In addition, the measuring unit 20 can be connected to a current measurement unit A. For example, the current measurement unit A may be an ammeter or shunt resistor that can measure the charging current and discharging current of the battery 10. The measuring unit 20 can calculate the charging amount by measuring the charging current of the battery 10 using the current measurement unit A. Additionally, the measuring unit 20 can calculate the discharge amount by measuring the discharge current of the battery 10 through the third sensing line SL3.

For example, the information about the voltage and capacity of the battery 10 measured by the measuring unit 20 may be transmitted to the profile obtaining unit 110. Additionally, the profile obtaining unit 110 can directly generate an OCV profile Rocv based on the received information about the voltage and capacity.

As another example, the information about the voltage and capacity of the battery 10 measured by the measuring unit 20 may be stored in the storage unit 140. When the charging or discharging of the battery 10 is completed, the profile obtaining unit 110 may access the storage unit 140 to obtain the OCV profile Rocv.

As still another example, the measuring unit 20 may directly generate an OCV profile Rocv based on the measured information about the voltage and capacity of the battery 10. In this case, the generated OCV profile Rocv may be transmitted to the profile obtaining unit 110 and also be stored in the storage unit 140.

A charge/discharge device or load can be connected to the positive electrode terminal P+ and the negative electrode terminal P- of the battery pack 1.

FIG. 16 is a diagram schematically showing an exemplary configuration of a vehicle according to still another embodiment of the present disclosure.

Referring to FIG. 16, the battery pack 1610 according to an embodiment of the present disclosure may be included in a vehicle 1600 such as an electric vehicle (EV) or a hybrid vehicle (HV). In addition, the battery pack 1610 may drive the vehicle 1600 by supplying power to a motor through an inverter included in the vehicle 1600. Here, the battery pack 1610 may include the apparatus 100 for estimating a SOH. That is, the vehicle 1600 may include the apparatus 100 for estimating a SOH.

In this case, the apparatus 100 may be an on-board diagnostic device included in the vehicle 1600. That is, the apparatus 100 can estimate the SOH of the battery in various aspects based on the OCV profile for the battery included in the vehicle 1600. Also, the apparatus 100 can provide information about the estimated SOH to the user.

A server according to still another embodiment of the present disclosure may include the apparatus 100 for estimating a SOH. For example, the server can receive the OCV profile Rocv from the BMS connected to the battery. As another example, the server may receive information about battery capacity and OCV from the BMS and directly generate an OCV profile Rocv based on the received information.

The server can generate an adjusted positive electrode profile and an adjusted negative electrode profile by adjusting the reference positive electrode profile Rp and the reference negative electrode profile Rn to correspond to the OCV profile Rocv. Additionally, the server can extract a diagnosis factor from the adjusted positive electrode profile and/or the adjusted negative electrode profile, and estimate the SOH for the battery based on the extracted diagnosis factor. Additionally, the server can provide state information about the battery by transmitting the information about the estimated SOH to the BMS.

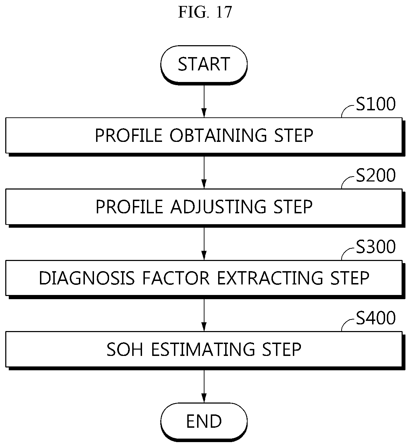

FIG. 17 is a diagram schematically showing a method for estimating a SOH according to still another embodiment of the present disclosure.

Referring to FIG. 17, the method for estimating a SOH may include a profile obtaining step (S100), a profile adjusting step (S200), a diagnosis factor extracting step (S300), and a SOH estimating step (S400).

Preferably, each step of the method for estimating a SOH can be performed by the apparatus 100 for estimating a SOH. Hereinafter, for convenience of explanation, content that overlaps with the content described above will be omitted or briefly described.

The profile obtaining step (S100) is a step of obtaining an OCV profile Rocv for a plurality of OCVs of a battery measured at different time points, and may be performed by the profile obtaining unit 110.

For example, the profile obtaining unit 110 may directly receive the OCV profile Rocv from the outside. That is, the profile obtaining unit 110 may obtain the OCV profile Rocv by receiving the OCV profile Rocv by being connected to the outside wired and/or wirelessly.

As another example, the profile obtaining unit 110 may receive battery information about the capacity and OCV of the battery. Additionally, the profile obtaining unit 110 may generate an OCV profile Rocv based on the received battery information. That is, the profile obtaining unit 110 may obtain the OCV profile Rocv by directly generating the OCV profile Rocv based on the battery information.

The profile adjusting step (S200) is a step of generating an adjusted positive electrode profile and an adjusted negative electrode profile by adjusting a preset reference positive electrode profile and a preset reference negative electrode profile to correspond to the OCV profile Rocv, and may be performed by the profile correcting unit 120.

For example, the profile correcting unit 120 may generate a plurality of comparison full-cell profile Ss by shifting the reference positive electrode profile Rp and the reference negative electrode profile Rn or scaling the capacity thereof, and specify a comparison full-cell profile S having a minimum error with the OCV profile Rocv among the plurality of comparison full-cell profile Ss. Also, an adjusted positive electrode profile and an adjusted negative electrode profile corresponding to the specified comparison full-cell profile S may be determined.

The diagnosis factor extracting step (S300) is a step of extracting a diagnosis factor for the battery from at least one of the adjusted positive electrode profile and the adjusted negative electrode profile, and may be performed by the control unit 130.

Specifically, the control unit 130 may extract a diagnosis factor related to the positive electrode from the adjusted positive electrode profile. Additionally, the control unit 130 may extract a diagnosis factor related to the negative electrode from the adjusted negative electrode profile.

For example, the positive electrode factor may include, may be based on or may be a function of at least one of the value of the positive electrode participation initiating point pi and the value of the positive electrode participation finalizing point pf of the battery based on the adjusted positive electrode profile. The negative electrode factor may include may be based on or may be a function of at least one of the value of the negative electrode participation initiating point ni, the value of the negative electrode participation finalizing point nf, and the negative electrode change rate ns of the battery based on the adjusted negative electrode profile.

The SOH estimating step (S400) is a step of estimating the SOH of the battery based on the extracted diagnosis factor, and may be performed by the control unit 130.

Specifically, the control unit 130 may estimate the SOH of the battery by comparing the value of the diagnosis factor with a reference value preset for the diagnosis factor. For example, the control unit 130 may estimate at least one of the positive electrode SOH, the negative electrode SOH, the available lithium SOH, and the capacity SOH for the battery depending on the type of diagnosis factor.

For example, the control unit 130 may estimate the positive electrode SOH ($SOH_P$) by referring to at least one of Equations 1 to 4. Alternatively or in addition, the control unit 130 may estimate the negative electrode SOH ($SOH_N$) with reference to one of Equations 5 to 8. Further alternatively or in addition, the control unit 130 may estimate the available lithium SOH ($SOH_{Li}$) by referring to one of Equations 9 to 11. Further alternatively or in addition, the control unit 130 may estimate the capacity SOH ($SOH_Q$) by referring to one of Equations 12 to 16.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

EXPLANATION OF REFERENCE SIGNS

1: battery pack

10: battery

20: measuring unit

100: apparatus for estimating a SOH

110: profile obtaining unit

120: profile correcting unit

130: control unit

140: storage unit

1600: vehicle

1610: battery pack

**Claims**

1. A battery diagnosis apparatus , comprising:

   a profile obtaining unit configured to obtain an OCV profile of a battery, the OCV profile being indicative of OCV as a function of a capacity;
   a profile correcting unit configured to generate a first profile by adjusting a first reference profile indicative of OCV as a function of a capacity, to correspond to the OCV profile; and
   a control unit configured to determine a state of the battery using the first profile.

2. The battery diagnosis apparatus of claim 1,

   wherein the profile correcting unit is configured to generate a second profile by adjusting a second reference profile to correspond to the OCV profile,
   wherein the first reference profile is a reference positive electrode profile, and the second reference profile is a reference negative electrode profile.

3. The battery diagnosis apparatus of claim 1 or 2,
   wherein the control unit is further configured to determine a diagnosis factor of the battery using the first profile and/or the second profile, and to determine the state of the battery as a function of the diagnosis factor.

4. The battery diagnosis apparatus according to any of the preceding claims, wherein the OCV profile is obtained from one or more of the following:

   an OCV measured when the battery is an idle state; and/or
   an OCV measured when the battery transitions from the idle state to a discharge state; and/or
   an OCV measured while a discharge current of the battery is equal to or less than a preset threshold current; and/or
   an OCV measured after or while the discharge current of the battery is maintained or has been maintained equal to or less than the preset threshold current for a predetermined duration.

5. The battery diagnosis apparatus according to any of the preceding claims,
   wherein the OCV profile is obtained from a plurality of OCV measurements of the battery that are measured within a reference period.

6. The battery diagnosis apparatus according to claim 5, wherein the reference period is either one of the following:

   - a predetermined or preconfigured time period; or
   - a period of time,

     ◦ in which a SOC of the battery progressively decreases by at least a threshold amount, e.g. 30%, at least 40%, at least 50% or more;
     ◦ required to perform a predetermined or preconfigured number of consecutive and/or periodic OCV measurements;
     ◦ in which a SOC of the battery decreases a lower threshold SOC, e.g. below 50%, below 40% or below 30%;
     ◦ in which OCVs obtained in a predetermined or preconfigured number of consecutive OCV measurements monotonously or strictly monotonously decrease over time; and/or
     ◦ between two charging cycles of the battery.

7. The battery diagnosis apparatus according to one of claim 2 or claims 3 to 6, when dependent on claim 2,
   wherein the profile correcting unit is configured to:

generate a comparison profile that is indicative of the OCV as a function of the capacity, from the first reference profile and the second reference profile,

adjust the first reference profile and the second reference profile so that the comparison profile corresponds to the OCV profile.

8. The battery diagnosis apparatus according to claim 7,
wherein the profile correcting unit is configured to obtain a target capacity range corresponding to the OCV profile and to compare the comparison profile and the OCV profile in the target capacity range.

9. The battery diagnosis apparatus according to any of the preceding claims,
wherein the state of the battery determined by the control unit comprises any, some or all of the following: a positive electrode state, a negative electrode state, an available lithium state, and a capacity state of the battery.

10. The battery diagnosis apparatus according to claim 3 or one of claims 4 to 9, when dependent on claim 3,
wherein the diagnosis factor comprises a positive electrode factor that is obtained from the first profile and/or a negative electrode factor that is obtained from the second profile.

11. The battery diagnosis apparatus according to claim 10,

wherein the positive electrode factor is based on at least one of a positive electrode participation initiating point, a positive electrode participation finalizing point, and a positive electrode change rate of the first profile of the battery, and
wherein the negative electrode factor is based on at least one of a negative electrode participation initiating point, a negative electrode participation finalizing point, and a negative electrode change rate of the second profile of the battery.

12. The battery diagnosis apparatus according to any of the preceding claims,
wherein the control unit is configured to automatically adjust a usage condition for the battery as a function of the state of the battery.

13. A battery pack, comprising the battery diagnosis apparatus according to any one of claims 1 to 12.

14. A vehicle or server, comprising the battery diagnosis apparatus according to any one of claims 1 to 12.

15. A battery diagnosis method, comprising:

obtaining an OCV profile of a battery, the OCV profile being indicative of OCV as a function of a capacity;
generating a first profile by adjusting a first reference profile indicative of OCV as a function of a capacity, to correspond to the OCV profile; and
determining a state of the battery using the first profile.

FIG. 1

APPARATUS FOR ESTIMATING SOH ~100

PROFILE OBTAINING UNIT ~110

PROFILE CORRECTING UNIT ~120

CONTROL UNIT ~130

STORAGE UNIT ~140

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

START

PROFILE OBTAINING STEP ⌐S100

PROFILE ADJUSTING STEP ⌐S200

DIAGNOSIS FACTOR EXTRACTING STEP ⌐S300

SOH ESTIMATING STEP ⌐S400

END

Europäisches
Patentamt

European
Patent Office

Office européen
des brevets

# EUROPEAN SEARCH REPORT

**Application Number**

EP 24 19 6702

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | US 2015/357852 A1 (NAKAO RYOUHEI [JP] ET AL) 10 December 2015 (2015-12-10)<br>* paragraphs [0055], [0058] *<br>* figures 3,4,6 *<br>* example 4 *<br>* claim 8 * | 1-10, 12-15<br>11 | INV.<br>G01R31/367<br>G01R31/392 |
| A | DE 10 2022 200007 A1 (BOSCH GMBH ROBERT [DE]) 6 July 2023 (2023-07-06)<br>* the whole document * | 1-15 | |
| A | CN 112 986 848 A (LIGAO SHANDONG NEW ENERGY TECH CO LTD) 18 June 2021 (2021-06-18)<br>* the whole document * | 1-15 | |
| A | EP 3 779 484 B1 (CONTEMPORARY AMPEREX TECHNOLOGY CO LTD [CN]) 30 November 2022 (2022-11-30)<br>* the whole document * | 1-15 | |
| A | US 10 371 753 B1 (WANG SHUOQIN [US] ET AL) 6 August 2019 (2019-08-06)<br>* the whole document * | 1-15 | **TECHNICAL FIELDS SEARCHED** (IPC)<br><br>G01R |
| A | CN 116 430 260 A (WUHAN POWER BATTERY REGENERATION TECH CO LTD ET AL.) 14 July 2023 (2023-07-14)<br>* the whole document * | 1-15 | |

The present search report has been drawn up for all claims

| Place of search | Date of completion of the search | Examiner |
|---|---|---|
| Munich | 23 January 2025 | Stussi, Elisa |

EPO FORM 1503 03.82 (P04C01)

**ANNEX TO THE EUROPEAN SEARCH REPORT
ON EUROPEAN PATENT APPLICATION NO.**

EP 24 19 6702

This annex lists the patent family members relating to the patent documents cited in the above-mentioned European search report.
The members are as contained in the European Patent Office EDP file on
The European Patent Office is in no way liable for these particulars which are merely given for the purpose of information.

23-01-2025

| Patent document cited in search report | Publication date | Patent family member(s) | | Publication date |
|---|---|---|---|---|
| US 2015357852 A1 | 10-12-2015 | JP | 6033155 B2 | 30-11-2016 |
| | | JP | 2014196985 A | 16-10-2014 |
| | | US | 2015357852 A1 | 10-12-2015 |
| | | WO | 2014156265 A1 | 02-10-2014 |
| DE 102022200007 A1 | 06-07-2023 | CN | 116381498 A | 04-07-2023 |
| | | DE | 102022200007 A1 | 06-07-2023 |
| CN 112986848 A | 18-06-2021 | NONE | | |
| EP 3779484 B1 | 30-11-2022 | CN | 110988690 A | 10-04-2020 |
| | | EP | 3779484 A1 | 17-02-2021 |
| | | US | 2021141028 A1 | 13-05-2021 |
| | | WO | 2020216082 A1 | 29-10-2020 |
| US 10371753 B1 | 06-08-2019 | NONE | | |
| CN 116430260 A | 14-07-2023 | NONE | | |

EPO FORM P0459

For more details about this annex : see Official Journal of the European Patent Office, No. 12/82